# EUROPEAN PATENT APPLICATION

(11) **EP 1 928 092 A2**
(43) Date of publication of application: **04.06.2008**
(21) Application number: 07122075.0
(22) Date of filing: 03.12.2007
(51) Int. Cl.: H03K 19/003, H03K 19/00

(54) **Semiconductor apparatus**

(30) Priority: 01.12.2006 JP 2006326339
(71) Applicant: MATSUSHITA ELECTRIC INDUSTRIAL CO., LTD, Kadoma-shi, Osaka 571-8501 (JP)
(72) Inventor: Mochizuki, Kouji c/o Matsushita Electric Industrial Co.,Ltd., Chuo-ku, Osaka 540-6207 (JP)
(74) Representative: Grünecker, Kinkeldey, Stockmair & Schwanhäusser Anwaltssozietät

(57) **Abstract**

A semiconductor apparatus that is effective for problems of local characteristic variations and that enables higher speed and lower power consumption. Semiconductor apparatus (100) has: a plurality of sensor circuits (101a) to (101g) which are arranged evenly inside semiconductor apparatus (100) and detect local characteristic variations at their respective positions as delay information; and output interface circuit (102) which collects delay information detected by a plurality of sensor circuits (101a) to (101g) and outputs the collected information to outside, and, in addition, externally, has: arithmetic operating section (110) which processes detected delay information statistically and generates a control code by judging conditions such as variations in the manufacturing process; output voltage controlling section (120) which determines the voltage to be outputted using a control code recorded in non-volatile memory (103); and power supply voltage generating section (130) which supplies power supply voltage (131a) and ground potential 131b to semiconductor apparatus (100).

## Description

### BACKGROUND OF THE INVENTION

### 1. Field of the Invention

The present invention relates to a semiconductor apparatus. More particularly, the present invention relates to a semiconductor apparatus that realizes high speed and low power consumption at the same time.

### 2. Description of the Related Art

There are a variety of methods of realizing lower power consumption of a semiconductor apparatus using CMOS (Complementary Metal Oxide Semiconductor) circuit, including making smaller a MOS transistor forming a CMOS circuit, decreasing the absolute value of the threshold voltage of the MOS transistor and reducing power supply voltage. However, generally, when the MOS transistor forming a CMOS circuit is made smaller, line resistance increases, higher speed is prevented, line resistance varies significantly and so synchronous design is prevented. Further, when threshold voltages of the MOS transistors are lowered, operation speed increases, but leakage currents increase. Furthermore, if power supply voltage is lowered, operation speed decreases.

On the other hand, if power supply voltage is increased to increase operation speed, power consumption increases and error operation of the circuit occurs due to characteristic variations of the MOS transistor such as operation noise and heating.

In this way, to improve the performance of the semiconductor apparatus using the CMOS circuit, higher speed and lower power consumption show a trade-off relationship, resulting in a significant problem.

To solve the above problem, the method of detecting factors which determine operation speed of the semiconductor apparatus using a specific method and controlling various elements supplied to the semiconductor apparatus based on the detection result has been adopted conventionally. For example, there is the circuit system disclosed in Patent Document 1 (Japanese Patent Application Laid-Open No. 2002-100967). Hereinafter, this circuit system will be referred to as the "first conventional example."

The first conventional example provides a similar or the same configuration as the "critical path," which generally refers to the circuit in a semiconductor apparatus where the timing margin, which refers to the difference between an allowable processing period and actual processing time for the logic circuit, as a sensor circuit provided outside the semiconductor apparatus which is the control target. The first example provides a means for measuring delay time between the time a signal is inputted in a sensor circuit and the time a signal is outputted from the sensor circuit, by dividing output signals from the PLL (Phase Locked Loop) circuit and using the amount of its delay for the time difference between the rising edge and the falling edge of the divided signal, and the control circuit, using that result, supplies the same power supply voltage to the semiconductor apparatus and sensor circuit.

Generally, the delay time becomes shorter when power supply voltage is higher and becomes longer when power supply voltage is lower. Power consumption of the semiconductor apparatus becomes greater when power supply voltage is higher and becomes less when power supply voltage is smaller.

In this way, the first conventional example carries out feedback operation such that power supply voltage is increased when the delay time of the sensor circuit is longer than the desired specified time and power supply voltage is decreased when the delay time is shorter than thedesiredspecifiedtime. With this feedback operation, power supply voltage sufficient for the desired specified time, that is, operation speed, is supplied to the semiconductor apparatus and sensor circuit, and, in addition, this supply is carried out based on continued feedback operation, so that this operation works effectively for characteristic variations of the MOS transistor caused by changes in ambient temperature.

In this way, the first conventional example can supply power supply voltage sufficient for the desired specified time, that is, operation speed, to the semiconductor apparatus under the condition reflecting changes in ambient temperature and solve the trade-off relationship between higher speed and lower power consumption.

Further, there is a circuit system disclosed in, for example, Patent Document 2 (Japanese Patent Application Laid-Open No.2001-345693) as a second method forsolvingtheaboveproblem. Hereinafter, this circuit system will be referred to as the "second conventional example."

The second conventional example provides a sensor circuit formed with a delay buffer and phase comparator inside the semiconductor apparatus. The delay time of the delay buffer varies following an increase of power supply voltage and temperature, and operation conditions of the sensor circuit and the semiconductor apparatus are detected by detecting the amount of variations and the phase difference with respect to the reference frequency signal. The second conventional example utilizes this detection result to control the three values of an increase or decrease of power supply voltage, an increase or decrease of clock frequency and an increase or decrease of substrate bias voltage.

Generally, when power supply voltage increases, although the delay time of the sensor circuit decreases, power consumption increases in proportion to the square of power supply voltage.

When the operating frequency increases, power consumption increases in proportion to operation speed and the margin between the delay time of the sensor circuit and the desired specified time decreases.

Further, when the substrate bias voltage moves closer to the drain voltage than the source voltage of the MOS transistor, although the delay time of the sensor circuit can be decreased, substrate leakage current increases. When the substrate bias voltage moves closer to the source voltage than the drain voltage, although the delay time of the sensor circuit increases, the substrate leakage current decreases.

Based on the above relationship, priority is set to control the three values of the increase or decrease of power supply voltage, the increase or decrease of clock frequency and the increase or decrease of substrate bias voltage, in accordance with requirement of the semiconductor apparatus, and this control is continuously carried out, so that it is possible to supply power supply voltage sufficient for the desired specified time, that is, operation speed, to the semiconductor apparatus under the condition reflecting changes in ambient temperature and, consequently, solve the trade-off relationship between higher speed and lower power consumption.

However, there is a following problem with this conventional semiconductor apparatus.

High-density resulting from recent developments in the micro-processing technique of semiconductor apparatuses brings about new problems. A particularly remarkable problem is local characteristic variations.

For example, line resistance of the power distribution of the semiconductor apparatus integrated with high-density takes values that cannot be ignored. The characteristic variations of the MOS transistor due to IR-drop where the source voltage of this MOS transistor locally changes every time current flows to the MOS transistor, cannot be ignored. The number of elements per unit area significantly increases, and so a case frequently occurs where the current flows locally and intensely depending on the operation condition. Further, the characteristic variation of the MOS transistor is becoming obvious due to a local temperature rise caused by Joule heat of the current, that is, local heating.

In addtion to these problems, characteristic variations due to actual MOS transistors and line directions and positions become obvious and cannot be ignored.

The first conventional example provides sensor circuits outside and therefore is not effective for these local characteristic variations. Further, the second conventional example provides a complicated sensor circuit and only arranges one or a few sensor circuits, and, therefore, is not effective in order to prevent power consumption increase resulting from addition of these sensor circuits.

### SUMMARY OF THE INVENTION

It is an object of the present invention to provide a semiconductor apparatus that is effective for local characteristic variations and that enables both higher speed and lower power consumption which usually show a trade-off relationship, in order to improve performance of the semiconductor apparatus using the MOS transistor.

According to an aspect of the invention, a semiconductor apparatus has: a main circuit that includes at least one MOS transistor and operates by receiving a supply of power supply voltage; a plurality of sensor circuits that are arranged in the main circuit and detect local characteristic variations at each position of the sensor circuits as delay information; an output interface circuit that collects detection results of the plurality of sensor circuits and outputs the collected results; an arithmetic operating section that statistically processes the detection results of the plurality of sensor circuits outputted from the output interface circuit; a power supply voltage controlling section that controls the power supply voltage supplied to the main circuit, based on the arithmetic operation result of the arithmetic operating section.

### BRIEF DESCRIPTION OF THE DRAWINGS

The above and other objects and features of the invention will appear more fully hereinafter from a consideration of the following description taken in connection with the accompanying drawing wherein one example is illustrated by way of example, in which;
FIG.1 is a block diagram showing a configuration of the semiconductor apparatus according to Embodiment 1 of the present invention;
FIG.2 is a circuit diagram showing a detailed configuration of a sensor circuit of the semiconductor apparatus according to this embodiment;
FIG.3 is a circuit diagram showing a detailed configuration of a multiphase PLL circuit of the semiconductor apparatus according to this embodiment;
FIG.4 is a timing diagram showing a phase output of the multiphase PLL circuit of FIG.3;
FIG.5 is a circuit diagram showing an example of a multiphase output ring oscillator of the semiconductor apparatus according to this embodiment;
FIG.6 illustrates in detail the even arrangement of sensor circuits of the semiconductor according to this embodiment;
FIG.7 illustrates in detail the even arrangement of the sensor circuits of the semiconductor according to this embodiment;
FIG.8 illustrates in detail the even arrangement of the sensor circuits of the semiconductor according to this embodiment;
FIG.9 is a flowchart showing statistical processing of an arithmetic operating section of the semiconductor apparatus according to this embodiment;
FIG.10 is a circuit block diagram showing a configuration of the semiconductor apparatus according to Embodiment 2 of the present invention;
FIG.11 is a circuit diagram showing a detailed configuration of the sensor circuit of the semiconductor apparatus according to this embodiment;
FIG.12 is a circuit diagram showing a detailed configuration of a buffer circuit forming a buffer chain circuit of the semiconductor apparatus according to this embodiment;
FIG.13 is a circuit block diagram showing a configuration of the semiconductor apparatus according to Embodiment 3 of the present invention;
FIG.14 is a circuit diagram showing a detailed configuration of the real circuit where the sensor circuits of the semiconductor apparatus according to this embodiment are arranged;
FIG.15 is a circuit block diagram showing a configuration of the semiconductor apparatus according to Embodiment 4 of the present invention;
FIG.16 shows a circuit configuration of the main circuit controlled by a phase controlling section of the semiconductor apparatus according to this embodiment;
FIG.17 is a circuit block diagram showing a configuration of the semiconductor apparatus according to Embodiment 5 of the present invention;
FIG.18 is a circuit block diagram showing a configuration of the semiconductor apparatus according to Embodiment 6 of the present invention;
FIG.19 is a circuit block diagram showing a configuration of the semiconductor apparatus according to Embodiment 7 of the present invention; and
FIG.20 is a circuit block diagram showing a configuration of the semiconductor apparatus according to Embodiment 8 of the present invention.

### DESCRIPTION OF THE PREFERRED EMBODIMENTS

Hereinafter, embodiments of the present invention will be described in detail with reference to attached drawings.

### (Embodiment 1)

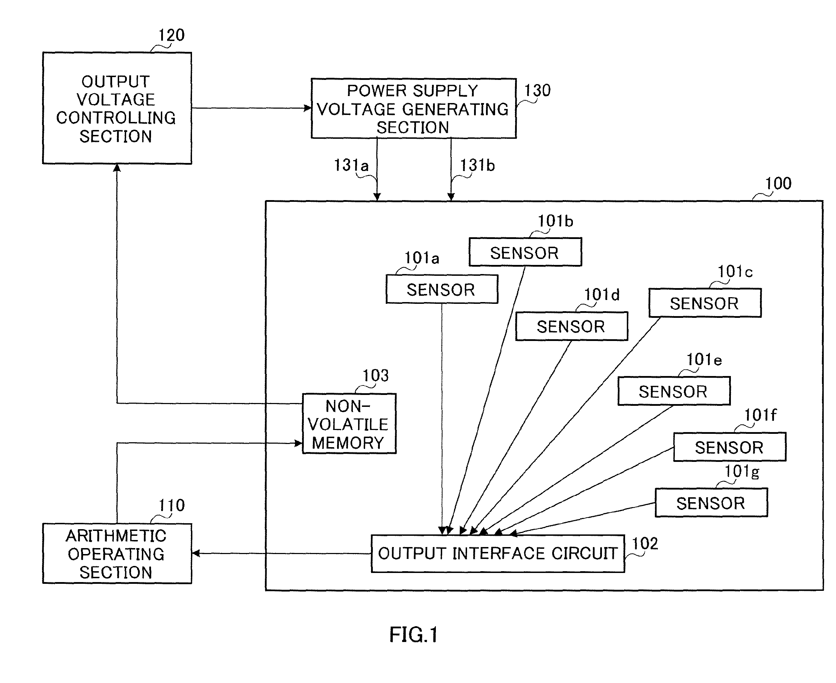

FIG.1 is a circuit block diagram showing a configuration of the semiconductor apparatus according to Embodiment 1 of the present invention. This embodiment provides an example of applying the present invention to a semiconductor integrated circuit that has a MOS transistor and that operates by receiving a supply of power supply voltage.

In FIG.1, the function blocks of the semiconductor apparatus are configured with: semiconductor apparatus 100 arranged on a single substrate by CMOS process and bipolar process; arithmetic operating section 110 which statistically processes detected delay information and generates a control code by judging conditions such as variations in the manufacturing process; output voltage controlling section 120 which determines the voltage to be outputted based on the control code recorded in non-volatile memory 103; and power supply voltage generating section 130 which supplies power supply voltage 131a and ground potential 131b to semiconductor apparatus 100.

Semiconductor apparatus 100 has: a plurality of sensor circuits 101a to 101g arranged evenly inside semiconductor apparatus 100 to detect delay values; output interface circuit 102 which collects delay information detected by a plurality of sensor circuits 101a to 101g and outputs the collected information to outside; and non-volatile memory 103 which records the control code generated by arithmetic operating section 110 in a unique value for each semiconductor apparatus 100.

Semiconductor apparatus 100 is a main circuit which has at least one MOS transistor and operates by receiving a supply of power supply voltage.

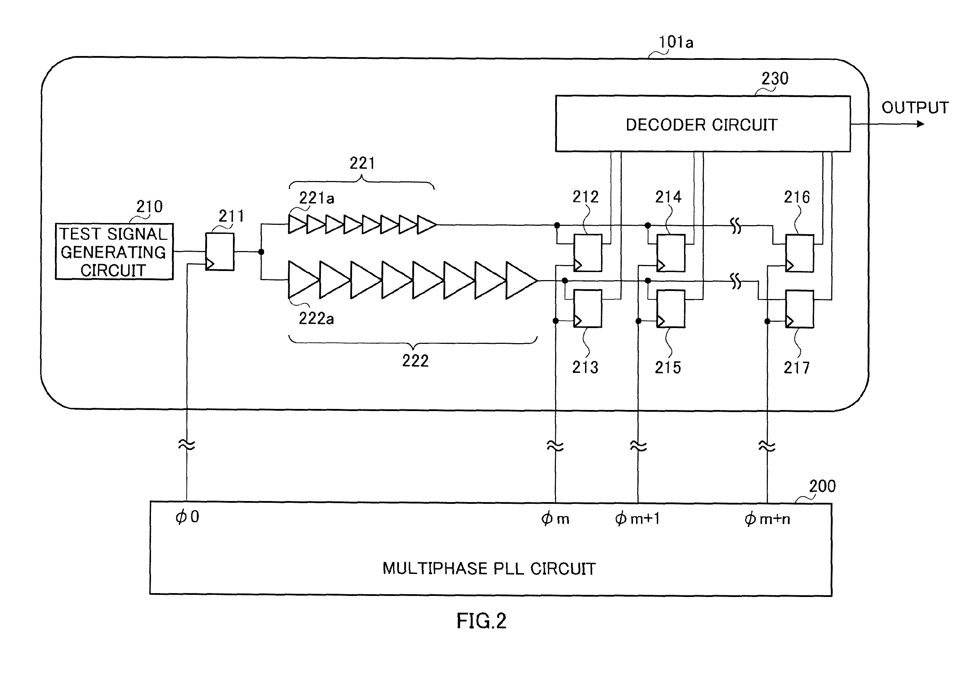

A plurality of (for example, dozens to several hundreds of) sensor circuits 101a to 101g are built in semiconductor apparatus 100 and detect a plurality of items of local delay information taking into account their respective positions and operation conditions. That is, a plurality of sensor circuits 101a to 101g are arranged in the main circuit and detect local characteristic variations at their respective positions as delay information. The configurations of sensor circuits 101a to 101g will be described in detail later with reference to FIG.2.

Output interface circuit 102 collects output results of a plurality of sensor circuits 101a to 101g and outputs the collected results to arithmetic operating section 110.

Arithmetic operating section 110 operates the output results of a plurality of sensor circuits 101a to 101g outputted from output interface circuit 102.

Non-volatile memory 103 saves the output result of arithmetic operating section 110 on a temporary basis.

Output voltage controlling section 120 controls the output voltage according to the output result of arithmetic operating section 110 saved in non-volatile memory 103.

Power supply voltage generating section 130 supplies power supply voltage to semiconductor apparatus 100 according to the control of output voltage controlling section 120.

FIG.2 is a circuit diagram showing the detailed configuration of sensor circuits 101a to 101g. Sensor circuits 101a to 101g employ the same configuration, and so sensor circuit 101a will be shown as a representative.

In FIG.2, multiphase PLL circuit 200 is used in common by all of sensor circuits 101a to 101g. Sensor circuit 101a shows the structure of one sensor circuit utilizing outputs with varying phases of multiphase PLL circuit 200.

Sensor circuit 101a is configured with: test signal generating circuit 210 which has an output terminal connected with a data input terminal of first flip flop circuit 211 and generates a test signal; flip flop (FF) circuits 211 to 217 which hold data using clocks with a plurality of varying phases ϕ₀ and ϕₘ to ϕ_{m + n} supplied from multiphase PLL circuit 200; first buffer chain circuit 221 and second buffer chain circuit 222 formed with a plurality of buffer circuits 221a and 222a of different capabilities; and decoder circuit 230 which is connected with output terminals of a plurality of flip flop circuits 211 to 217 and calculates the delay time difference between outputs of first and second buffer chain circuits 221 and 222.

Test signal generating circuit 210 generates the test signal shown in table 1 and outputs pulse signals.

**[Table 1]**

| TEST SIGNAL | VARIATIONS IN MANUFACTURING PROCESS | | THERMO CODES FOR FLIP FLOP CIRCUITS 212, 214 AND 216 | THERMO CODES FOR FLIP FLOP CIRCUITS 213, 215 AND 217 | EXAMPLES OF DECODING RESULTS REFLECTING DIFFERENCE BETWEEN THERMO CODES | |
|---|---|---|---|---|---|---|
| PULSE SIGNAL | TRANSISTOR SPEED | SLOW | 0000_0001 | 0000_1111 | 000 | SLOW |
| | | NORMAL | 0000_0011 | 0011_1111 | 010 | NORMAL |
| | | FAST | 0000_0111 | 1111_1111 | 100 | FAST |

Table 1 is a truth value table for test signal generating circuit 210.

Flip flop circuit 211 is the first flip flop circuit which has an input terminal connected with an output terminal of test signal generating circuit 210 and has a data output terminal connected with a common input terminal of first and second buffer chain circuits 221 and 222.

First buffer chain circuit 221 and second buffer chain circuit 222 are formed with a plurality of buffer circuits 221a and 222a of different capabilities. The capability difference between buffer circuits 221a and 222a is shown by changing symbol marks of buffers in different sizes. Further, although in FIG.2 the number of buffer circuits 221a of first buffer chain circuit 221 and the number of buffer circuits 222a of second buffer chain circuit 222 are the same, a configuration may be configured with different numbers of buffer circuits.

That is, any configuration is possible where first buffer chain circuit 221 and second buffer chain circuit 222 of different capabilities and different numbers of the buffer circuits are connected in common with the data output terminal of flip flop circuit 211 in parallel, and the delay time difference between outputs of first and second buffer chain circuit 221 and 222 is generated.

Flip flop circuits 212 to 217 have data input terminals connected with output terminals of first and second buffer chain circuits 221 and 222.

In this way, a configuration is provided where, in sensor circuit 101a (FIG.2) as an element of a plurality of sensor circuits 101a to 101g shown in FIG.1, clock signals supplied to a plurality of flip flop circuits 212 to 217 having the data input terminals connected with a plurality of output terminals of first flip flop circuit 211 and first and second buffer chain circuits 221 and 222, are supplied from multiphase PLL circuit 200 as mutliphase clocks with random varying phases.

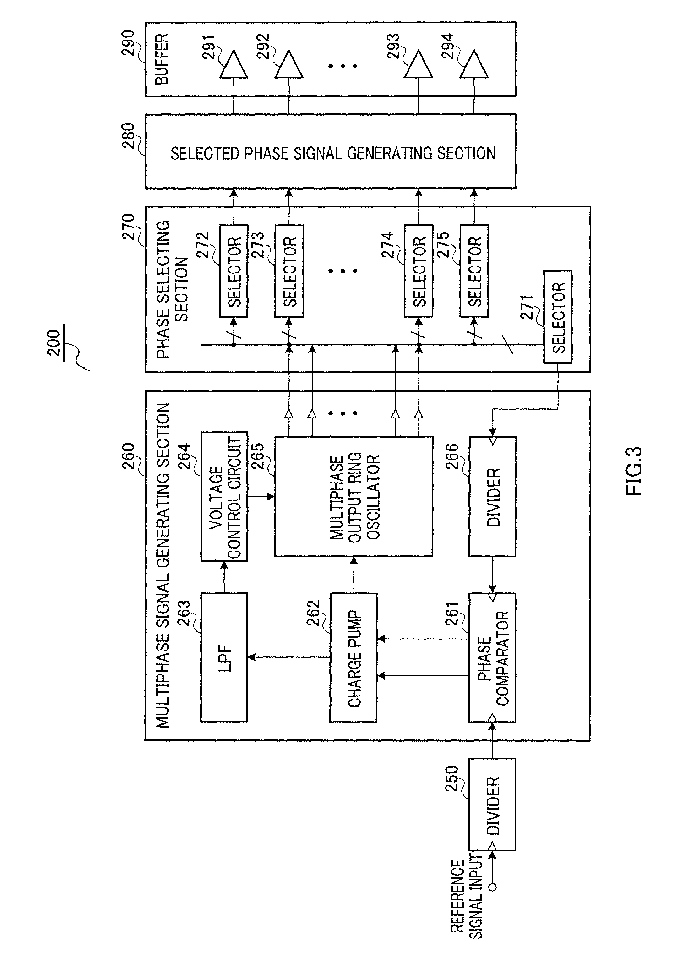

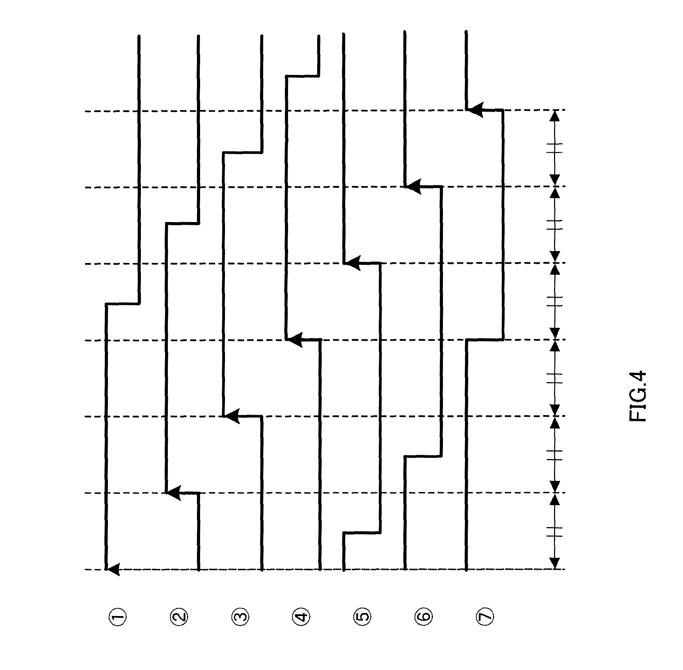

FIG.3 is a circuit diagram showing a detailed configuration of above multiphase PLL circuit 200. FIG.4 is a timing chart showing phase outputs from multiphase PLL circuit in FIG.3.

In FIG.3, multiphase PLL circuit 200 has divider 250 which divides a reference signal, multiphase signal generating section 260, phase selecting section 270, selected phase signal generating section 280 and buffer sections 290. Multiphase signal generating section 260 has phase comparator 261, charge pump circuit 262, LPF 263, voltage control circuit 264, multiphase output ring oscillator 265 and divider 266. Phase selecting section 270 has selectors 271 to 275. Buffer section 290 has buffer circuits 291 to 294.

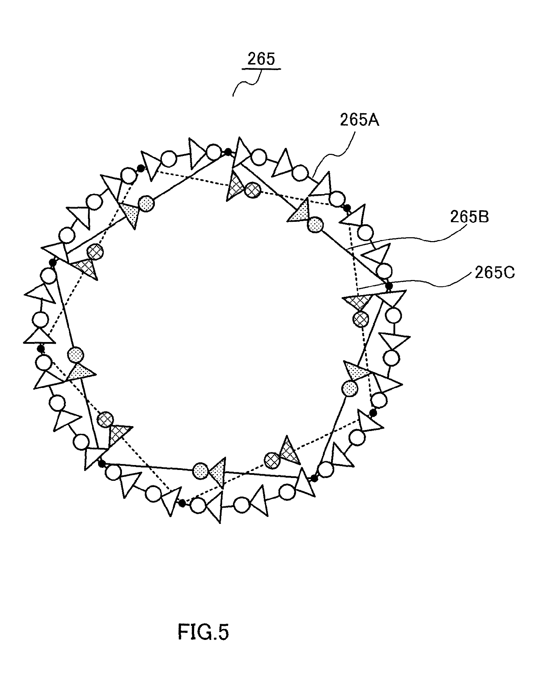

FIG.5 is a circuit diagram showing an example of above multiphase output ring oscillator 265.

As shown in FIG. 5, multiphase output ring oscillator 265 has different numbers of ring oscillators 265A, 265B and 265C, and realizes multiphase outputs.

As described above, features of this embodiment include (1) making sensor circuits 101a to 101g for detecting delay values in different configurations from conventional sensor circuits, (2) arranging a large number of sensor circuits 101a to 101g evenly in semiconductor apparatus 100, and (3) generating a control code by statistically processing detection results of a large number of sensor circuits 101a to 101g by arithmetic operating section 110.

Next, an example will be described where a large number of sensor circuits 101a to 101g are arranged evenly in semiconductor apparatus 100.

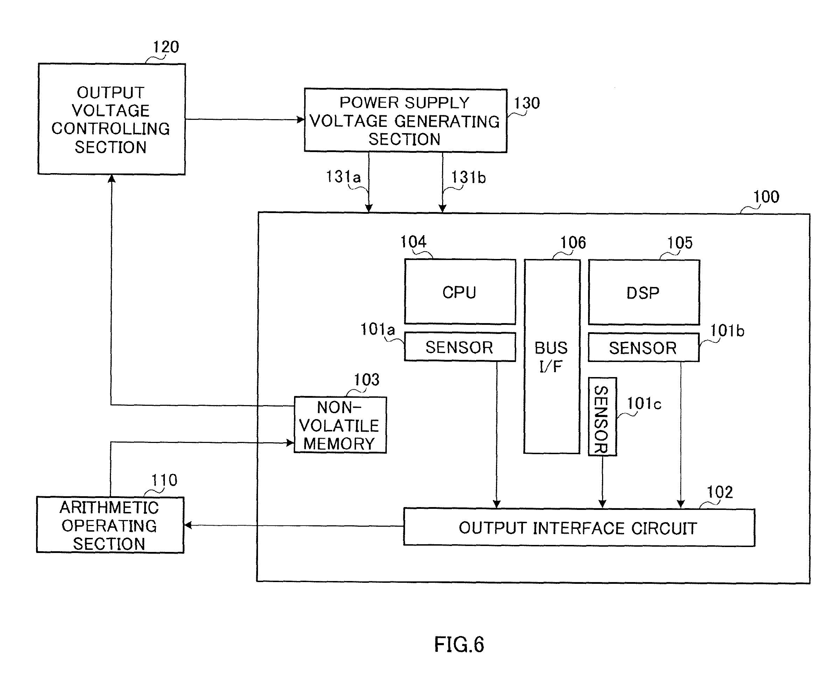

FIG.6 to FIG.8 illustrate in detail the even arrangement of sensor circuits 101a to 101g.

[Arrangement example 1, where sensor circuits are evenly arranged]

FIG.6 illustrates that three sensor circuits 101a to 101c are arranged evenly near CPU, DSP (Digital Signal Processor) and the bus.

In FIG.6, semiconductor apparatus 100 has CPU 104, DSP 105 and bus interface 106 inside. Three sensor circuits 101a to 101c are arranged near CPU 104, DSP 105 and bus interface 106.

[Arrangement example 2, where sensor circuits are evenly arranged]

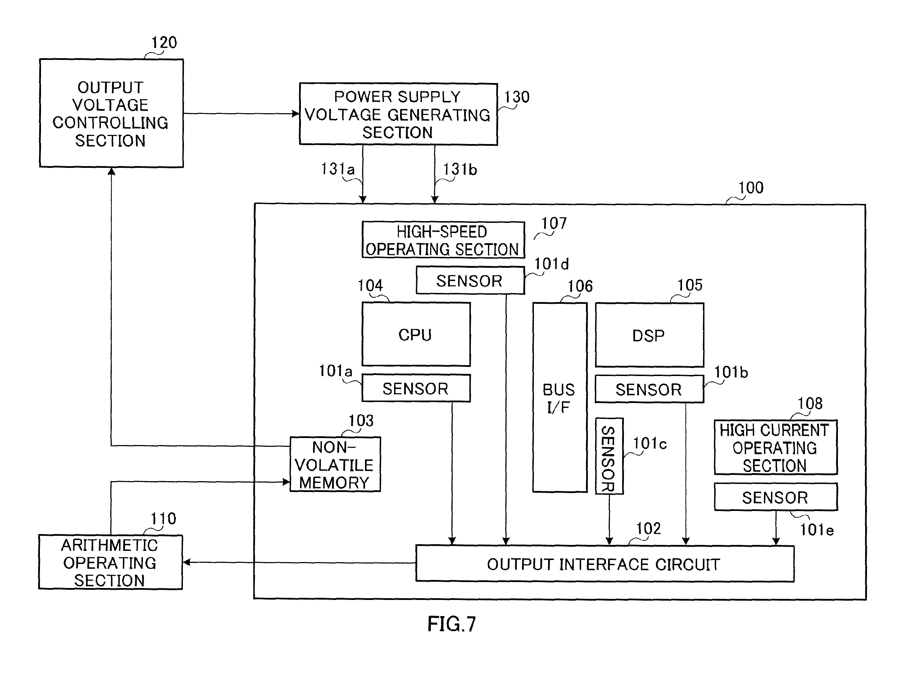

FIG.7 illustrates that five sensor circuits 101a to 101e are evenly arranged at parts where temperature rises and high current occurs.

In FIG.7, semiconductor apparatus 100 has CPU 104, DSP 105, bus interface 106, high-speed operating section 107 and high current operating section 108 inside. Five sensor circuits 101a to 101e are arranged near CPU 104, DSP 105, bus interface 106, high-speed operating section 107 and high current operating section 108.

[Arrangement example 3, where sensor circuits are evenly arranged]

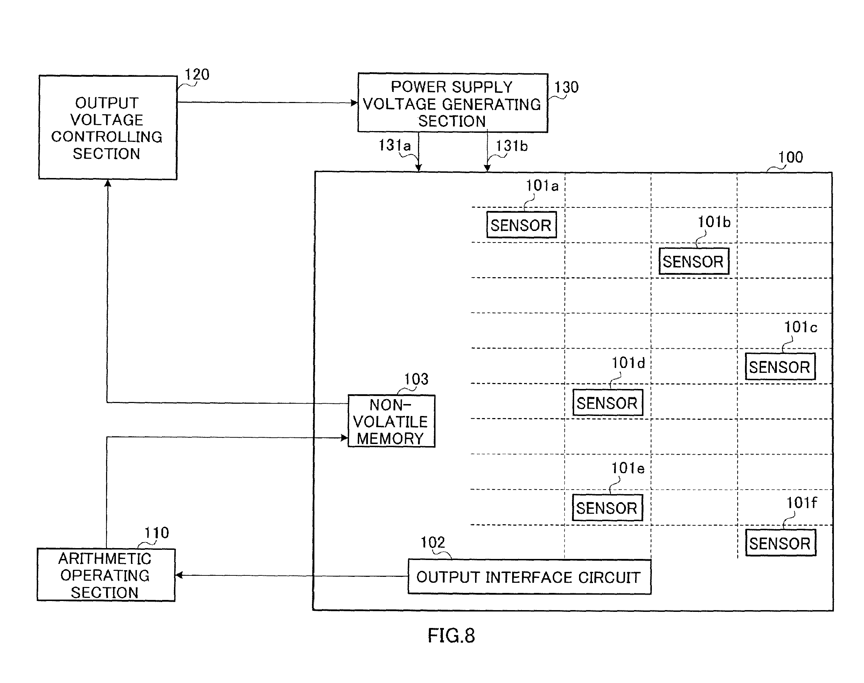

FIG.8 illustrates that sensor circuits 101a to 101f are evenly arranged by area matrix division and random arrangement.

As shown by the broken lines in FIG. 8, semiconductor apparatus 100 are subjected to area matrix division into predetermined divisions and sensor circuits 101a to 101f are randomly arranged on the areas subjected to area matrix division.

Hereinafter, the operation of the semiconductor apparatus configured as described above will be described.

Multiphase clocks maintaining predetermined phase relationships are outputted as outputs with varying phases from multiphase PLL circuit 200, irrespective of temperature, power supply voltage and variations in the manufacturing process. As shown in FIG.4, multiphase clocks including rising edges with offsets for, for example, regular time intervals of every dozen of pico seconds, are sequentially inputted to flip flop circuits 211 to 217 from multiphase PLL circuit 200.

Small-sized test signal generating circuit 210 is built in each sensor circuit 101a to 101f. First, a test signal is inputted by flip flop circuit 211 both to first buffer chain circuit 221 and second buffer chain circuit 222 of different capabilities, at the timing of phase ϕ₀. For example, if the test signal is a rising pulse signal that changes from low to high, pulse signals that transfer through first buffer chain circuit 221 and second buffer chain circuit 222 are outputted at different timings from first buffer chain circuit 221 and second buffer chain circuit 222 due to the capability difference between first buffer chain circuit 221 and second buffer chain circuit 222.

The output terminals of first buffer chain circuit 221 and second buffer chain circuit 222 are connected with flip flop circuits 212 to 217, multiphase clocks with phases ϕₘ and ϕ_{m + 1} to ϕ_{m + n}, offsets for regular time intervals and rising edges are inputted to flip flop circuits 212 to 217, so that outputs of flip flop circuits 212 to 217 include thermo codes reflecting individual capabilities of first buffer chain circuit 221 and second buffer chain circuit 222 (see [table 1]). Then, decoder circuit 230 converts this thermo code signal to a unique output signal, for example, an unsigned two bit signal. As a result, sensor circuit 101a can detect changes of output timings at first buffer chain circuit 221 and second buffer chain circuit 222 by taking into account local heat, IR-drop and variations in the manufacturing process comprehensively.

In this way, sensor circuit 101a shown in FIG.2 can detect local heat, IR-drop and variations in the manufacturing process at their respective positions, so that semiconductor apparatus 100, in which sensor circuits 101a to 101g are evenly arranged, detect local heat, IR-drop and variations in the manufacturing process at each position of the sensor circuits.

These detection results are inputted to arithmetic operating section 110 through output interface circuit 102. Arithmetic operating section 110 statistically processes the maximum value, minimum value and distribution of detected delay information, and generates a control code as a statistical processing result.

The generated control code is recorded in non-volatile memory 103 on a temporary basis. A case is assumed here as an example where arithmetic operating section 110 is implemented using an LSI tester and its program to prevent operation circuit increase. In this case, the generated control code that is unique to semiconductor apparatus 100 is not immediately inputted to output voltage controlling section 120, and so needs to be recorded in non-volatile memory 103 on a temporary basis.

Further, when semiconductor apparatus 100 actually operates, the control code recorded in non-volatile memory 103 is read by output voltage controlling section 120, and output voltage controlling section 120 controls power supply voltage generating section 130 to supply power supply voltage 131a and ground potential 131b such that power consumption is minimized when semiconductor apparatus 100 operates.

Next, the statistical processing and control code will be described.
1. The significance of the statistical processing will be described.
   Following recent developments in the manufacturing process of deep submicron LSI's, micro-processing errors such as manufacturing errors of optical elements in lithography are becoming equally or more obvious than above macro-processing errors. For this reason, in the current deep submicron LSI, variations of characteristics such as delay values of cells in a chip show random high fluctuations in the overall LSI. Although the delay values of all cells in this chip need to satisfy the design standard to minimize power consumption of the LSI, it is not possible to directly measure the delay values of all cells. When macro process errors are dominant as in the conventional LSI manufacturing process, if the first tipping tendency and the second tipping tendency in this manufacturing process are learned in advance, by arranging several sensor circuits at the center of or around the LSI, it is possible to calculate delay values of all cells in a chip using measurement results of several sensor circuits.
   However, in the recent submicron LSI manufacturing process, micro-processing errors such as manufacturing errors of optical elements in lithography are dominant and the above first tipping tendency and second tipping tendency do not occur. In order to estimate delay values of all cells as much as possible, the only method that is available is to arrange dozens of sensor circuits or more over an LSI per LSI, calculate the average value and 3σ of measurement results of the sensor circuits and statistically estimate the limit value using the value of average value plus 3σ.
   As described above, the statistical processing is a method required to estimate the delay values of all cells in the LSI as much as possible, and dozens of sensor circuits need to be arranged over the LSI for the statistical processing.
2. The significance of control code will be described.
   As described above, it is necessary to carry out statistical processing using dozens of delay values or more, to estimate the delay values of all cells inside the LSI as much as possible. However, if the timing of the cell of the greatest delay value is not too late, timings of other cells come in time. Further, for example, by taking into account the fact that delay values tend to decrease following the increase of power supply voltage, control information for the cell having the greatest delay value may be a sufficient control value.

It is possible to prevent the LSI circuit increase byspecifyingminimum necessarycontrolinformation,that is, the control code, insteadof using measurement results of sensor circuits having a large amount of information (that is, largenumberofbits) or the half-finished result of the statistical processing. The "control code" refers here to a code which is provided in the arithmetic operating section and which matches one by one to the delay value of the cell having the greatest delay value and controls power supply voltage.

Arithmetic operating section 110 may be built in the LSI. However, realizing arithmetic operating section 110 using an LSI tester can reduce the circuit area for statistical processing and may make a more preferable embodiment. However, when external factors such as heat variations continue changing, although the circuit area increases, it is possible to realize lower power consumption by building arithmetic operating section 110 in the LSI and carrying out adaptive control at regular intervals

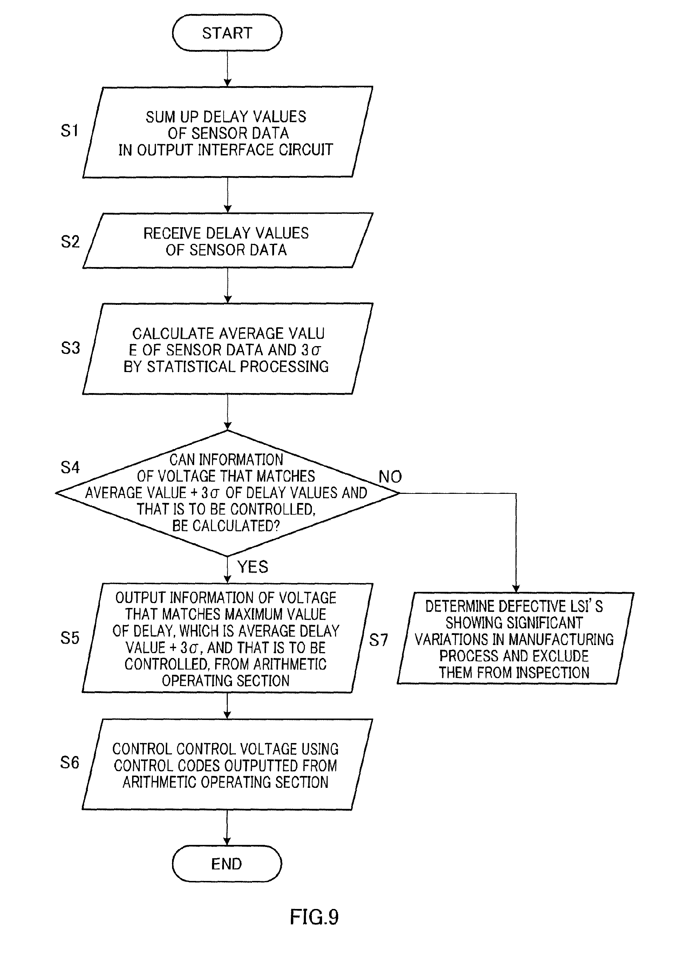

FIG.9 is a flowchart showing the statistical processing of arithmetic operating section 110 of semiconductor apparatus 100. In this figure, "S" stands for a step.

First, in step S1, delay values of sensor data are summed up in output interface circuit 102, and, in step S2, the delay values of sensor data are received. Next, in step S3, the value of average value of the sensor data and 3σ is calculated by statistical processing.

In step S4, whether information of the voltage that matches average value plus 3σ of the delay values and that is to be controlled, can be calculated is judged. When information of the voltage to be controlled cannot be calculated, in step S7, the defective LSI's showing significant variations in the manufacturing process are excluded from inspection.

When the information of the voltage to be controlled can be calculated in step S4, arithmetic operating section 110 outputs, in step S5, information of the voltage that matches the maximum value of delay, which is average value plus 3σ, and that is to be controlled. Next, in step S6, output voltage controlling section 120 controls the control voltage using a control code outputted from arithmetic operating section 110 and the flow is finished.

As described above in detail, semiconductor apparatus 100 according to this embodiment has: a plurality of sensor circuits which are arranged evenly inside and detect local characteristic variations at their respective positions as delay information; output interface circuit 102 which collects delay information detected by a plurality of sensor circuits 101a to 101g and sends out the collected information to outside; and non-volatile memory 103 which records a control code generated by arithmetic operating section 110 in a unique value for each semiconductor apparatus 100, and, in addition externally, semiconductor apparatus 100 has: arithmetic operating section 110 which statistically processes the detected delay information and generates the control code by judging conditions such as variations in the manufacturing process; output voltage controlling section 120 which determines the voltage to be outputted using the control code recorded in non-volatile memory 103; and power supply voltage generating section 130 which supplies power supply voltage 131a and ground potential 131b to semiconductor apparatus 100, so that, by statistically processing delay information obtained by dozens or several hundreds of sensor circuits 101a to 101g arranged evenly inside semiconductor apparatus 100, it is possible to prevent miss detection as to local characteristic variations upon design. Further, by locally arranging sensor circuits 101a to 101g, it is possible to accurately measure characteristic variations due to IR-drop, local heating, sensor circuit directions and positions and, consequently, enable both higher speed and lower power consumption.

With this embodiment, a large number of sensor circuits 101a to 101g for detecting delay values are arranged evenly in semiconductor apparatus 100, a control code is generated by statistically processing detection results of a large number of sensor circuits 101a to 101g, and power supply voltage 131a and ground voltage 131b are supplied such that power consumption is minimized when semiconductor apparatus 100 operates. By using this control code and controlling power supply voltage and potential, it is possible to enable both higher speed and lower power consumption, taking into account local heat, IR-drop and variations in the manufacturing process at each position of the sensor circuits. Accordingly, it is possible to realize a semiconductor apparatus that is realized by a larger number of processes and that, by reflecting local variations such as IR-drop and local heating in addition to variations in the manufacturing process and changes in ambient temperature, enables both high speed and low power consumption, which usually show a trade-off relationship, to improve performance of the semiconductor apparatus using the MOS transistor.

Although an example has been described above with this embodiment where arithmetic operating section 110, output voltage controlling section 120 and power supply voltage generating section 130 are arranged outside semiconductor apparatus 100, part or all of these elements may be built in semiconductor apparatus 100. Further, arithmetic operating section 110 may not be necessarily an LSI tester and may be a semiconductor apparatus on a single substrate or on a single set.

### (Embodiment 2)

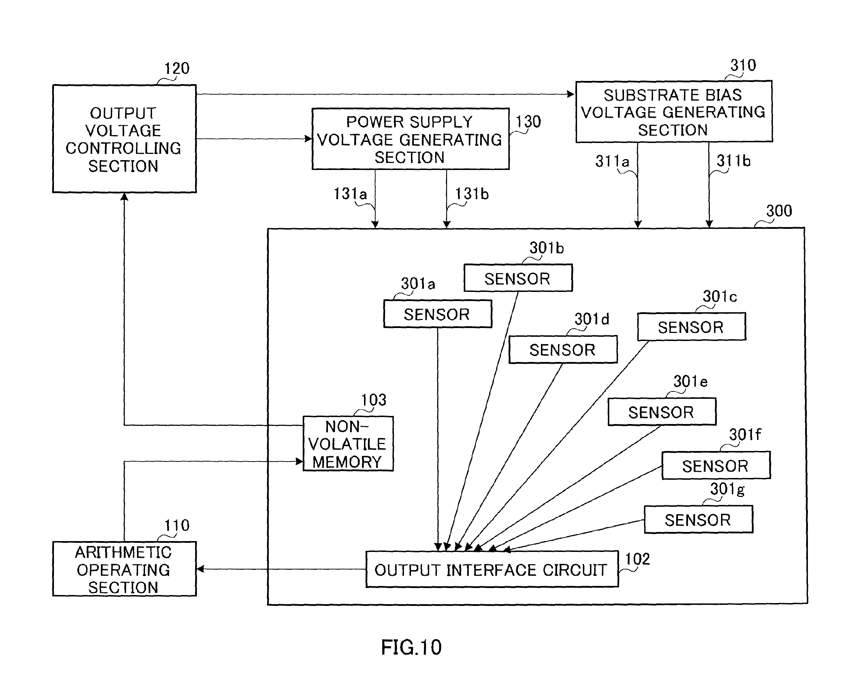

FIG.10 is a circuit block diagram showing a configuration of a semiconductor apparatus according to Embodiment 2 of the present invention. This embodiment provides a more preferable configuration example of a plurality of sensor circuits arranged evenly inside the semiconductor apparatus. The same elements as in FIG.1 will be assigned the same reference numerals and overlapping description will be omitted.

In FIG. 10, the function blocks of the semiconductor apparatus are configured with: semiconductor apparatus 300 arranged on a single substrate by CMOS process and bipolar process; arithmetic operating section 110 which statistically processes detected delay information and generates a control code by judging conditions such as variations in the manufacturing process; output voltage controlling section 120 which determines the voltage to be outputted based on the control code recorded in non-volatile memory 103; power supply voltage generating section 130 which supplies power supply voltage 131a and ground potential 131b to semiconductor apparatus 100; and substrate bias voltage generating section 310 which supplies PMOS transistor substrate bias voltage 311a and NMOS transistor substrate bias voltage 311b to semiconductor apparatus 300.

Semiconductor apparatus 300 has: a plurality of sensor circuits 301a to 301g arranged evenly inside semiconductor apparatus 300 to detect delay values; output interface circuit 102 which collects delay information detected by a plurality of sensor circuits 301a to 301g and outputs the collected information to outside; and non-volatile memory 103 which records the control code generated by arithmetic operating section 110 in a unique value for each semiconductor apparatus 300.

Semiconductor apparatus 300 is a main circuit which has at least one MOS transistor and operates by receiving a supply of power supply voltage.

A plurality of (for example, dozens to several hundreds of) sensor circuits 301a to 301g are built in semiconductor apparatus 300 and detect local characteristic variations at their respective positions as delay information.

Output interface circuit 102 collects output results of a plurality of sensor circuits 301a to 301g and outputs the collected results to arithmetic operating section 110.

Arithmetic operating section 110 operates the output results of a plurality of sensor circuits 301a to 301g outputted from output interface circuit 102.

Output voltage controlling section 120 controls the output voltage according to the output result of arithmetic operating section 110 saved in non-volatile memory 103.

Power supply voltage generating section 130 supplies power supply voltage to semiconductor apparatus 300 according to the control of output voltage controlling section 120.

Substrate bias voltage generating section 310 supplies the substrate potential of the P-channel MOS transistor and the substrate potential of the N-channel MOS transistor to the main circuit (semiconductor apparatus 300) , according to the control of output voltage controlling section 120. Substrate bias voltage generating section 310 is able to individually control the substrate potential of the P-channel MOS transistor and the substrate potential of the N-channel MOS transistor, according to operation performance required for the whole of the main circuit and the overall circuit condition of the main circuit.

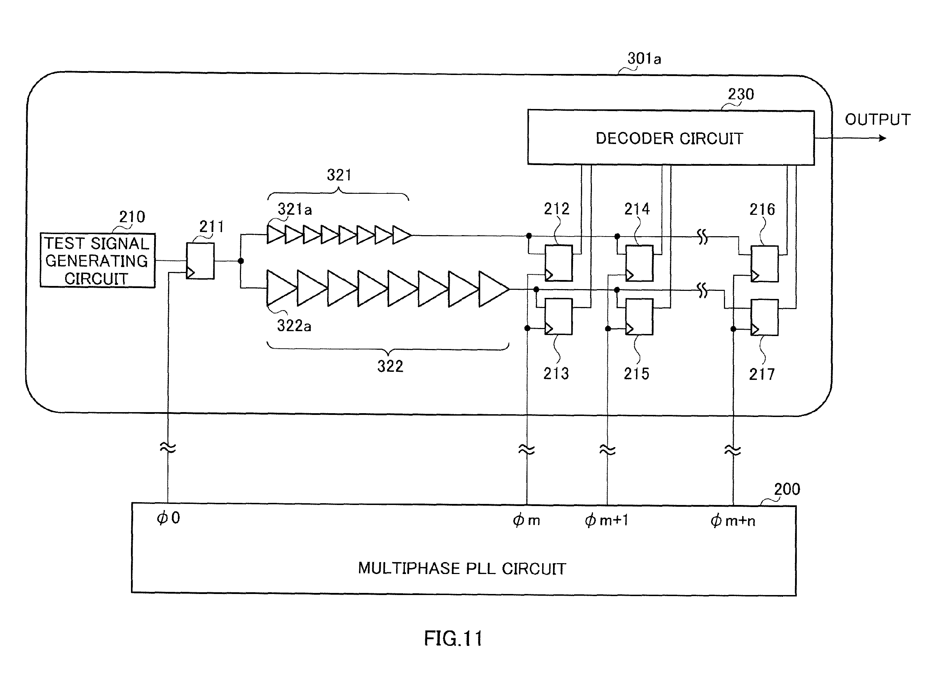

FIG.11 is a circuit diagram showing the detailed configuration of sensor circuits 101a to 101g. Sensor circuits 301a to 301g employ the same configuration, and so sensor circuit 301a will be shown as a representative.

In FIG.11, sensor circuit 301a shows the structure of one sensor circuit utilizing outputs with varying phases of multiphase PLL circuit 200.

Sensor circuit 301a is configured with: test signal generating circuit 210 which has an output terminal connected with a data input terminal of first flip flop circuit 211 and generates a test signal; flip flop (FF) circuits 211 to 217 which hold data using clocks with a plurality of varying phases ϕ₀ and ϕₘ to ϕ_{m + n} supplied from multiphase PLL circuit 200; first buffer chain circuit 321 and second buffer chain circuit 322 formed with a plurality of different buffer circuits 321a and 322a of different capabilities; and decoder circuit 230 which is connected with output terminals of a plurality of flip flop circuits 211 to 217 and calculates the delay time difference between outputs of first and second buffer chain circuits 321 and 322.

Test signal generating circuit 210 generates the test signal shown in above table 1 and outputs pulse signals.

Flip flop circuit 211 is the first flip flop circuit which has an input terminal connected with an output terminal of test signal generating circuit 210 and has a data output terminal connected with a common input terminal of first and second buffer chain circuits 321 and 322.

First buffer chain circuit 321 and second buffer chain circuit 322 are formed with a plurality of buffer circuits 321a and 322a of different capabilities. The capability difference between buffer circuits 321a and 322a is shown by changing symbol marks of buffers in different sizes. Further, although in FIG.11 the number of buffer circuits 321a of first buffer chain circuit 321 and the number of buffer circuits 322a of second buffer chain circuit 322 are the same, a configuration may be configured with different numbers of buffer circuits.

That is, any configuration is possible where first buffer chain circuit 321 and second buffer chain circuit 322 of different capabilities and different numbers of buffer circuits are connected in common with the data output terminal of flip flop circuit 211 in parallel, and the delay time difference between outputs of first and second buffer chain circuit 321 and 322 is generated.

Flip flop circuits 212 to 217 have data input terminals connected with output terminals of first and second buffer chain circuits 321 and 322.

In this way, a configuration is provided where, in sensor circuit 301a (FIG.11) as an element of a plurality of sensor circuits 301a to 301g shown in FIG.10, clock signals supplied to a plurality of flip flop circuits 212 to 217 having the data input terminals connected with a plurality of first flip flop circuit 211 and first and second buffer chain circuits 321 and 322, are supplied frommultiphase PLL circuit 200 as multiphase clocks with random varying phases.

Multiphase clocks maintaining predetermined phase relationships are outputted as outputs with varying phases from multiphase PLL circuit 200, irrespective of temperature, power supply voltage and variations in the manufacturing process. In FIG.11, multiphase clocks including rising edges with offsets for, for example, regular time intervals of every dozen of pico seconds, are sequentially inputted to flip flop circuits 211 to 217.

Test signal generating circuit 210 is a small-sized test signal generating circuit built in each sensor circuit 301a to 301g. First, a test signal is inputted by flip flop circuit 211 both to first buffer chain circuit 221 and second buffer chain circuit 322 of different capabilities, at the timing of phase ϕ₀.

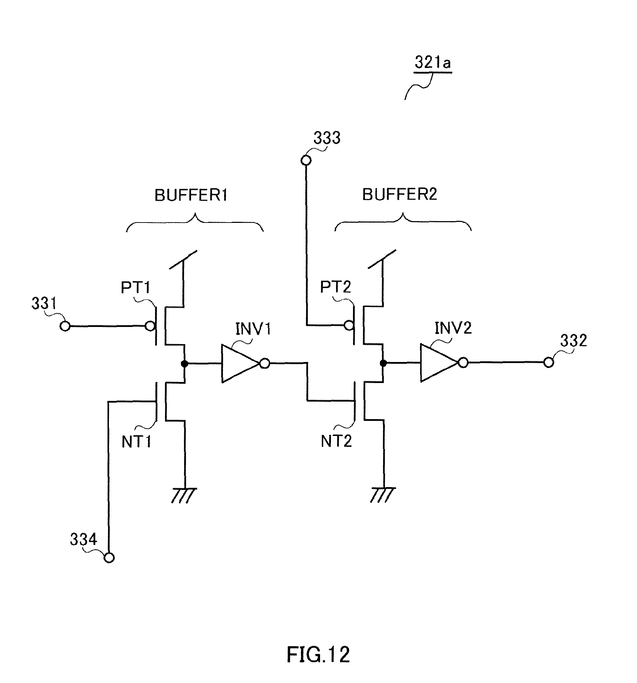

It is possible to improve the accuracy of delay time detection more than Embodiment 1 by employing the buffer circuit which will be described with reference to FIG. 12, to the buffers forming first buffer chain circuit 321 and second buffer chain circuit 322.

Similar to Embodiment 1, features of this embodiment include (1) making sensor circuits 301a to 301g for detecting delay values in different configurations from conventional sensor circuits, (2) arranging a large number of sensor circuits 301a to 301g evenly in semiconductor apparatus 300, and (3) generating a control code by statistically processing detection results of a large number of sensor circuits 301a to 301g by arithmetic operating section 110.

The detailed example is described with reference to above FIG.6 to FIG.8 where a large number of sensor circuits 301a to 301g of above (2) are arranged evenly in semiconductor apparatus 300.

FIG.12 is a circuit diagram showing the detailed configuration of buffer circuits 321a and 322a forming buffer chain circuits 321 and 322 of different capabilities. Buffer circuits 321a and 322a employ the same configuration, and so buffer circuits 321a will be shown as a representative.

In FIG.12, buffer circuit 321a is configured with: first PMOS transistor PT1 which has the gate terminal connected with input terminal 331; first NMOS transistor NT1 which has the gate terminal to which the first DC bias voltage is applied through first DC bias voltage applying terminal and has the drain terminal connected with the drain terminal of first PMOS transistor PT1; inverter circuit INV1 has an input terminal connected with the drain terminal of first PMOS transistor PT1 and the drain terminal of first NMOS transistor NT1; second NMOS transistor NT2 which has the gate terminal connected with an output terminal of above first inverter circuit INV1; second PMOS transistor PT2 which has the gate terminal to which second DC bias voltage is applied through second DC bias voltage applying terminal 333 and has the drain terminal connected with the drain terminal of above second NMOS transistor NT2; second inverter circuit INV2 which has an input terminal connected with the drain terminal of second NMOS transistor NT2 and the drain terminal of second PMOS transistor PT2; output terminal 332 which outputs the output from second inverter circuit INV2 as an output from buffer circuit 321a.

Second DC bias voltage applying terminal 333 is a DC bias voltage applying terminal for a PMOS transistor for limiting the rising slew rate for a buffer. First DC bias voltage applying terminal 334 is a DC bias voltage applying terminal for an NMOS transistor for limiting a rising slew rate for a buffer.

The combination of first inverter circuit INV1 and an inverter formed with first PMOS transistor PT1 and first NMOS transistor NT1 forms buffer 1 of the first stage. The combination of second inverter circuit INV2 and an inverter formed with second PMOS transistor PT2 and second NMOS transistor NT2 forms buffer 2 of the second stage. Therefore, to apply the buffer structure shown in FIG.12 to buffer chain circuits 321 and 322 shown in FIG.11, the number of stages for buffer chain circuits 321 and 322 is eight, and so four of the buffer circuits shown in FIG.12 are used. Further, although in FIG.12 an example has been described where the number of buffer circuits 321 and the number of buffers circuit 322 are the same, any combination may be possible if the combination of buffers of different capabilities is provided and any number of buffer circuits maybe possible.

Hereinafter, the operation of the semiconductor apparatus configured as described above will be described. The basic operation is the same as in Embodiment 1 and repetition of description will be omitted. The characteristic operation of this embodiment will be described.

With this embodiment, it is possible to improve the accuracy of delay time detection more than Embodiment 1 by employing buffer circuit 321a shown in FIG.12, to buffer circuits 321a and 321b forming as elements first buffer chain circuit 321 and second buffer chain circuit 322 of different capabilities.

In buffer circuit 321a shown in FIG.12, the rising time and the falling time for a signal can be adjusted at random based on the applied voltages from second DC bias voltage applying terminal 333 for PMOS transistor PT2 and first bias voltage applying terminal 334 for NMOS transistor NT1. That is, the rising time and the falling time for the buffer signal can be set long enough for the phase resolution of multiphase PLL circuit 200, so that, in Embodiment 2, it is possible to improve the accuracy of delay time detection more than Embodiment 1.

For example, in these sensor circuits 301a to 301g, if the test signal is a rising pulse signal that changes from low to high, pulse signals that transfer through first buffer chain circuit 321 and second buffer chain circuit 322 are outputted at different timings from first buffer chain circuit 321 and second buffer chain circuit 322 due to the capability difference between first buffer chain circuit 321 and second buffer chain circuit 322.

The output terminals of first buffer chain circuit 321 and second buffer chain circuit 322 are connected with flip flop circuits 212 to 217, multiphase clocks with phases ϕₘ and ϕ_{m + 1} to ϕ_{m + n}, offsets for regular time intervals and rising edges are inputted to flip flop circuits 212 to 217, so that outputs of flip flop circuits 212 to 217 include thermo codes reflecting individual capabilities of first buffer chain circuit 321 and second buffer chain circuit 322 (see above [table 1]). Then, decoder circuit 230 converts this thermo code signal to a unique output signal, for example, an unsigned two-bit signal. As a result, sensor circuit 301a to 301g can detect changes of output timings at first buffer chain circuit 321 and second buffer chain circuit 322 by taking into account local heat, IR-drop and variations in the manufacturing process comprehensively.

In this way, sensor circuit 301a to 301g shown in FIG.11 can detect local heat, IR-drop and variations in the manufacturing process at their respective positions.

The detection results are inputted to arithmetic operating section 110 through output interface circuit 102. Arithmetic operating section 110 statistically processes the maximum value, minimum value and distribution of detected delay information, and generates a control code as a statistical processing result.

The generated control code is recorded in non-volatile memory 103 on a temporary basis. A case is assumed here as an example where arithmetic operating section 110 is implemented using an LSI tester and its program to prevent arithmetic operation circuit increase. In this case, the generated control code that is unique to semiconductor apparatus 300 is not immediately inputted to output voltage controlling section 120, and so needs to be recorded in non-volatile memory 103 on a temporary basis.

Further, when semiconductor apparatus 300 actually operates, the control code recorded in non-volatile memory 103 is read by output voltage controlling section 120, and output voltage controlling section 120 supplies PMOS transistor substrate bias voltage 311a and NMOS transistor substrate bias voltage 311b such that threshold voltage Vtp of the PMOS transistor and threshold voltage Vtn of the NMOS transistor forming semiconductor apparatus 300 are minimized, from substrate bias voltage generating section 310. Next, output voltage controlling section 120 controls from power supply voltage generating section 130 to supply power supply voltage 131a and ground potential 131b such that power consumption is minimized when semiconductor apparatus 300 for which the threshold voltages are adjusted as described above, operates.

As described above, with this embodiment, a large number of sensor circuits 301a to 301g for detecting delay values are arranged evenly in individual semiconductor apparatuses 300, a control code is generated by statistically processing detection results of a large number of sensor circuits by arithmetic operating section 110, and power supply voltage 131a and ground voltage 131b are supplied such that power consumption is minimized when semiconductor apparatus 300 operates, so that it is possible to enable both higher speed and lower power consumption, taking into account local heat, IR-drop and variations in the manufacturing process at each position of the sensor circuits.

Particularly, with this embodiment, by employing buffer circuit 321a shown in FIG.12, to buffer circuits 321a and 321b forming as elements first buffer chain circuit 321 and second buffer chain circuit 322 of different capabilities, the rising time and the falling time for the buffer signal can be set long enough for the phase resolution of multiphase PLL circuit 200, so that it is possible to further improve the accuracy of delay time detection compared to Embodiment 1.

Although an example has been described above with this embodiment where arithmetic operating section 110, output voltage controlling section 120, power supply voltage generating section 130 and substrate bias voltage generating section 310 are arranged outside semiconductor apparatus 300, part or all of these elements may be built in semiconductor apparatus 300. Further, arithmetic operating section 110 may not be necessarily an LSI tester and may be a semiconductor apparatus on a single substrate or on a single set.

### (Embodiment 3)

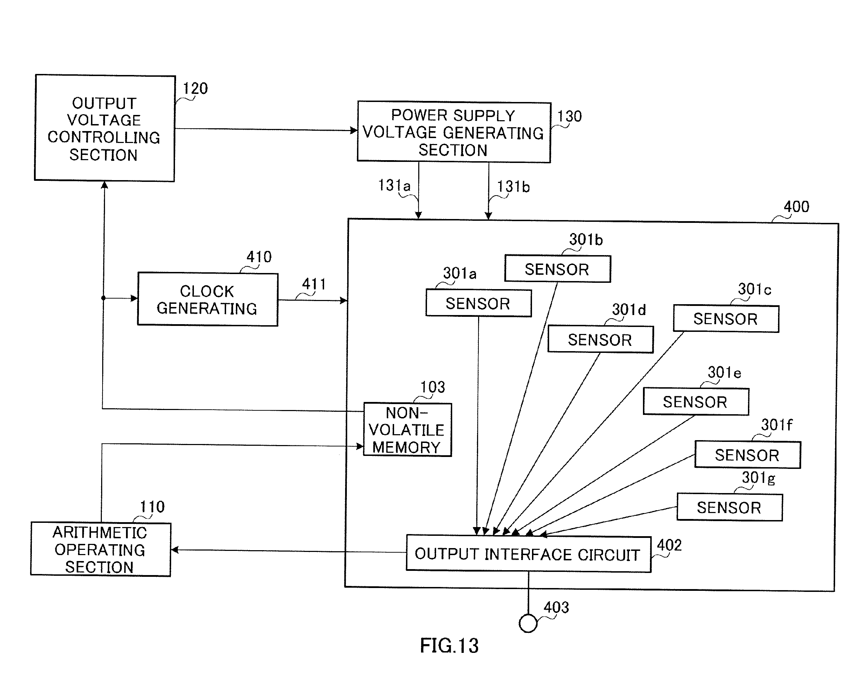

FIG.13 is a circuit block diagram showing a configuration of the semiconductor apparatus according to Embodiment 3 of the present invention. This embodiment provides an example of applying the present invention to a semiconductor integrated circuit that carries out feedback control by reflecting the arithmetic result obtained by statistically processing sensor circuit outputs, in power supply voltage and clock frequency. The same elements as in FIG.10 will be assigned the same reference numerals and overlapping description will be omitted.

In FIG.13, the function blocks of the semiconductor apparatus are configured with: semiconductor apparatus 400 arranged on a single substrate by CMOS process and bipolar process; arithmetic operating section 110 which processes detected delay information statistically and generates a control code by judging conditions such as variations in the manufacturing process; output voltage controlling section 120 which determines the voltage to be outputted using the control code recorded in non-volatile memory 103; power supply voltage generating section 130 which supplies power supply voltage 131a and ground potential 131b to semiconductor apparatus 400; clock generating section 410 which supplies operation clock signal 411 to semiconductor apparatus 400; and mode setting terminal 403 which controls an operation mode of semiconductor apparatus 400 from outside.

Semiconductor apparatus 400 has: a plurality of sensor circuits 301a to 301g arranged evenly inside semiconductor apparatus 400 to detect delay values; output interface circuit 402 which collects delay information detected by a plurality of sensor circuits 301a to 301g and outputs the collected information to outside; and non-volatile memory 103 which records the control code generated by arithmetic operating section 110 in a unique value for each semiconductor apparatus 400.

Semiconductor apparatus 400 is a main circuit which has at least one MOS transistor and operates by receiving a supply of power supply voltage.

A plurality of sensor circuits 301a to 301g are built in semiconductor apparatus 400 and detect a plurality of items of local delay information taking into account their respective positions and operation conditions.

Output interface circuit 402 is connected with mode setting terminal 403 for controlling the operation mode of semiconductor apparatus 400 from outside, collects output results of a plurality of sensor circuits 301a to 301g and outputs the collected results.

Arithmetic operating section 110 operates the output results of a plurality of sensor circuits 301a to 301g outputted from output interface circuit 402.

Output voltage controlling section 120 controls the output voltage according to the output result of arithmetic operating section 110 saved in non-volatile memory 103.

Power supply voltage generating section 130 supplies power supply voltage to semiconductor apparatus 400 according to the control of output voltage controlling section 120.

Clock generating section 410 supplies clock signals to the main circuit (semiconductor apparatus 400), according to the output result of arithmetic operating section 110. Clock generating section 410 is able to individually control clock signals according to operation performance required for the whole of the main circuit and the overall circuit condition of the main circuit.

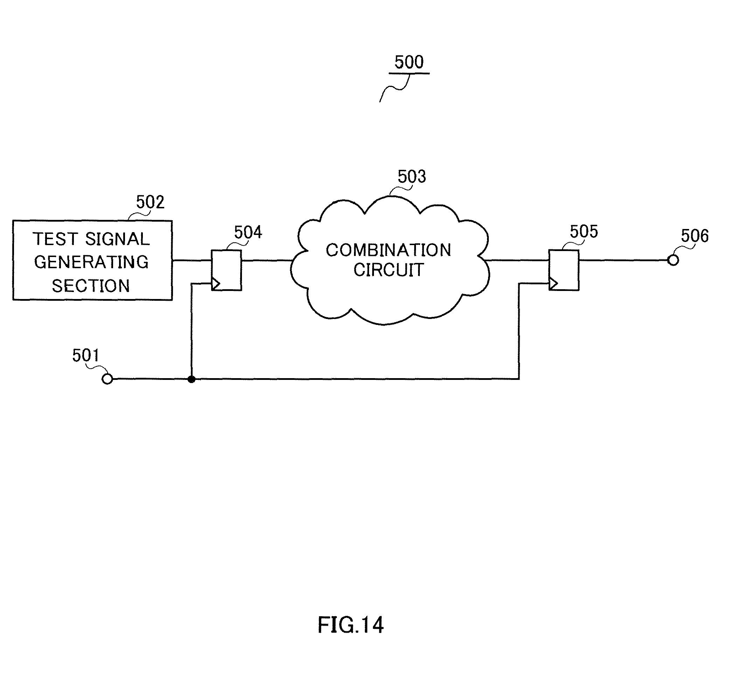

FIG.14 is a circuit diagram showing a detailed configuration of the real circuit where sensor circuits 301a to 301g are arranged.

In FIG.14, real circuit 500 where sensor circuits 301a to 301g are arranged, is configured with: clock input terminal 501 for clocks supplied to sensor circuits 301a to 301g; test signal generating section 502 which generates test signals for sensor circuits 301a to 301g; combination circuit 503 which is a circuit where sensor circuits 301a to 301g are arranged and which has the same or a very similar circuit structure or wire structure; flip flop circuits 504 and 505 which restrict the timings of input and output of combination circuit 503 using clock signals inputted from clock input terminal 501; and output terminal 506 of a sensor circuit.

The logic of combination circuit 503 is partly or entirely the same as the real circuit laid out at the position where combination circuit 503 is actually arranged and driving capability of combination circuit 503 becomes the same as or similar to the main circuit. The logic of combination circuit 503 is partly or entirely the same as the real circuit laid out at the position where combination circuit 503 is actually arranged and each cell is arranged in the same direction.

Similar to Embodiments 1 and 2, features of this embodiment include (1) making sensor circuits 301a to 301g for detecting delay values in different configurations from conventional sensor circuits, (2) arranging a large number of sensor circuits 301a to 301g evenly in semiconductor apparatus 400, and (3) generating a control code by statistically processing detection results of a large number of sensor circuits 301a to 301g by arithmetic operating section 110.

The detailed example is described with reference to above FIG.6 to FIG.8 where a large number of sensor circuits 301a to 301g of above (2) are arranged evenly in semiconductor apparatus 400.

The clock signal inputted from clock input terminal 501 is supplied by clock generating section 410 of FIG.13.

Generally, a unique, fixed value is set for the clock frequency supplied to semiconductor apparatus 400 according to restrictions of timings or processing times of systems integrated in semiconductor apparatus 400. Further, generally, it is possible to extend the processing time or pause the processing, depending on the setting condition of mode setting terminal 403. A case is described with this embodiment as an example where, depending on the setting condition of mode setting terminal 403, when an extension of processing time or a pause is commanded in addition to normal operation, power supply voltage 131a and ground potential 131b are supplied optimally, so that it is possible to enable higher speed and lower power consumption.

Hereinafter, the operation of the semiconductor apparatus configured as described above will be described. The basic operation is the same as in Embodiments 1 and 2 and repetition of description will be omitted. The characteristic operation of this embodiment will be described.

In the normal operation mode, clock generating section 410 supplies operation clock signal 411 of the frequency determined in advance by system requirement. Operation clock signals 411 are inputted to clock input terminal 501 of sensor circuits 301a to 301g.

For example, if the test signal outputted from test signal generating section 502 is a rising pulse signal that changes from low to high, combination circuit 503 carries out signal input, operation processing and output at the timing specified by the frequency of operation clock signal 411. However, when power supply voltage is not sufficient and the capability of the MOS transistor decreases due to variations in the manufacturing process, IR-drop and local heating, the desired output signal cannot be obtained. In this case, output voltage controlling section 120 controls power supply voltage generating section 130 to adjust the voltage such that the difference between power supply voltage 131a and ground potential 131b increases. This voltage adjustment control is repeated until the output values of all combination circuits 503 of sensor circuits 301a to 301g become equal to the desired value or until the output values of all combination circuits 503 within the range of 3σ of delay variations of sensor circuits statistically calculated from all of sensor circuits 301a to 301g by arithmetic operating section 110 become equal to the desired value. As a result, a control code matching the final determined values of power supply voltage 131a and ground potential 131b is the value to be stored in non-volatile memory 103.

Although the above description focuses upon the normal operation mode, when the setting condition of mode setting terminal 403 shows an extension of processing time, the frequency of operation clock signal 411 of clock generating section 410 and the clock frequency inputted to clock input terminal 501 are decreased based on mode requirement, and a control code is set, so that the difference between power supply voltage 131a and ground potential 131b becomes less compared to the case of the normal operation mode. When the setting condition of mode setting terminal 403 shows a pause, the frequency of operation clock signal 411 of clock generating section 410 and the clock frequency inputted to clock input terminal 501 are stopped (that is, fixed), so that the difference between power supply voltage 131a and ground potential 131b is lowered to the potential difference where an internal signal condition does not change due to leakage or noise. Then, a control code for outputting the difference between power supply voltage 131a and ground potential 131b matching the setting condition of each mode setting terminal 403 is stored in non-volatile memory 103.

A case is assumed here as an example where the above control is implemented using an LSI tester and its program. In this case, the generated control code that is unique to semiconductor apparatus 400 is not immediately inputted to output voltage controlling section 120, and so needs to be recorded in non-volatile memory 103 on a temporary basis.

Then, when semiconductor apparatus 400 actually operates, first, operation clock signal 411 matching the setting condition of mode setting terminal 403 is inputted from clock generating section 410, and, next, a control code matching the setting condition of mode setting terminal 403 is read in output voltage controlling section 120 from non-volatile memory 103. Output voltage controlling section 120 controls power supply voltage generating section 130 to supply power supply voltage 131a and ground potential 131b such that power consumption is minimized when semiconductor apparatus 400 operates.

As described above, with this embodiment, a large number of sensor circuits 301a to 301g for detecting delay values are arranged evenly in semiconductor apparatus 400, a control code is generated by statistically processing detection results of a large number of sensor circuits by reflecting the setting condition of mode setting terminal 403, and power supply voltage 131a and ground voltage 131b can be supplied such that power consumption is minimized when semiconductor apparatus 400 operates, so that it is possible to enable both higher speed and lower power consumption, taking into account local heat, IR-drop and variations in the manufacturing process at each position of the sensor cirucits.

Although an example has been described above with this embodiment where arithmetic operating section 110, output voltage controlling section 120, power supply voltage generating section 130 and clock generating section 410 are arranged outside semiconductor apparatus 400, part or all of these elements may be built in semiconductor apparatus 400. Further, arithmetic operating section 110 may not be necessarily an LSI tester and may be a semiconductor apparatus on a single substrate or on a single set.

### (Embodiment 4)

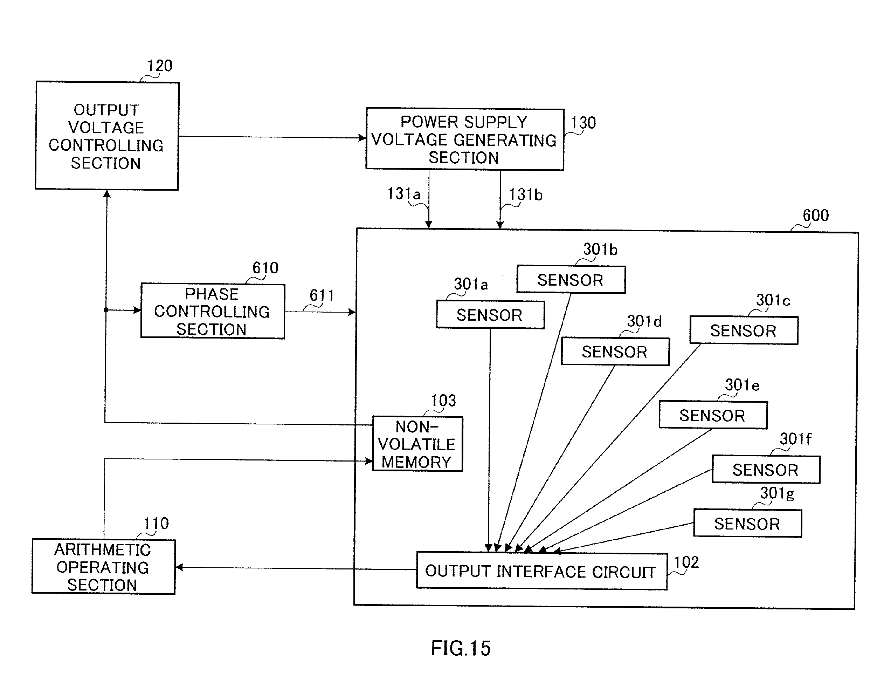

FIG.15 is a circuit block diagram showing a configuration of the semiconductor apparatus according to Embodiment 4 of the present invention. This embodiment provides an example applying the present invention to a semiconductor integrated circuit that carries out feedback control by reflecting the arithmetic operation result obtained by statistically processing sensor circuit outputs, in power supply voltage and clock frequency. This embodiment provides an example of applying the present invention to a semiconductor integrated circuit with five function blocks that respectively have internal memories. The same elements as in FIG.10 are assigned the same reference numerals and overlapping description will be omitted.

In FIG. 15, the function blocks of the semiconductor apparatus are configured with: semiconductor apparatus 600 arranged on a single substrate by CMOS process and bipolar process; arithmetic operating section 110 which statistically processes detected delay information and generates a control code by judging conditions such as variations in the manufacturing process; output voltage controlling section 120 which determines the voltage to be outputted based on the control code recorded in non-volatile memory 103; power supply voltage generating section 130 which supplies power supply voltage 131a and ground potential 131b to semiconductor apparatus 600; and phase controlling section 610 which controls the clock phase supplied from semiconductor apparatus 600.

Semiconductor apparatus 600 has: a plurality of sensor circuits 301a to 301g arranged evenly inside semiconductor apparatus 600 to detect delay values; output interface circuit 102 which collects delay information detected by a plurality of sensor circuits 301a to 301g and outputs the collected information to outside; and non-volatile memory 103 which records the control code generated by arithmetic operating section 110 in a unique value for each semiconductor apparatus 600.

Semiconductor apparatus 600 is a main circuit which includes at least one MOS transistor and operates by receiving a supply of power supply voltage.

A plurality of sensor circuits 301a to 301g are built in semiconductor apparatus 600 and detect a plurality of items of delay information taking into account their respective positions and operation conditions.

Output interface circuit 102 collects output results of a plurality of sensor circuits 301a to 301g and outputs the collected results to arithmetic operating section 110.

Arithmetic operating section 110 operates the output results of a plurality of sensor circuits 301a to 301g outputted from output interface circuit 102.

Output voltage controlling section 120 controls the output voltage according to the output result of arithmetic operating section 110 saved in non-volatile memory 103.

Power supply voltage generating section 130 supplies power supply voltage to semiconductor apparatus 600 according to the control of output voltage controlling section 120.

Phase controlling section 610 supplies phase control signal 611 to the main circuit (semiconductor apparatus 600), according to the control of output result of arithmetic operating section 110. Phase controlling section 610 includes a phase controlling section and is able to individually control phase control signals according to operation performance required for the whole of the main circuit and the overall circuit condition of the main circuit.

Similar to Embodiment 1 to 3, features of this embodiment include (1) making sensor circuits 301a to 301g for detecting delay values in different configurations from conventional sensor circuits, (2) arranging a large number of sensor circuits 301a to 301g evenly in semiconductor apparatus 600, and (3) generating a control code by statistically processing detection results of a large number of sensor circuits 301a to 301g by arithmetic operating section 110.

The detailed example is described with reference to above FIG.6 to FIG.8 where a large number of sensor circuits 301a to 301g of above (2) are arranged evenly in semiconductor apparatus 600.

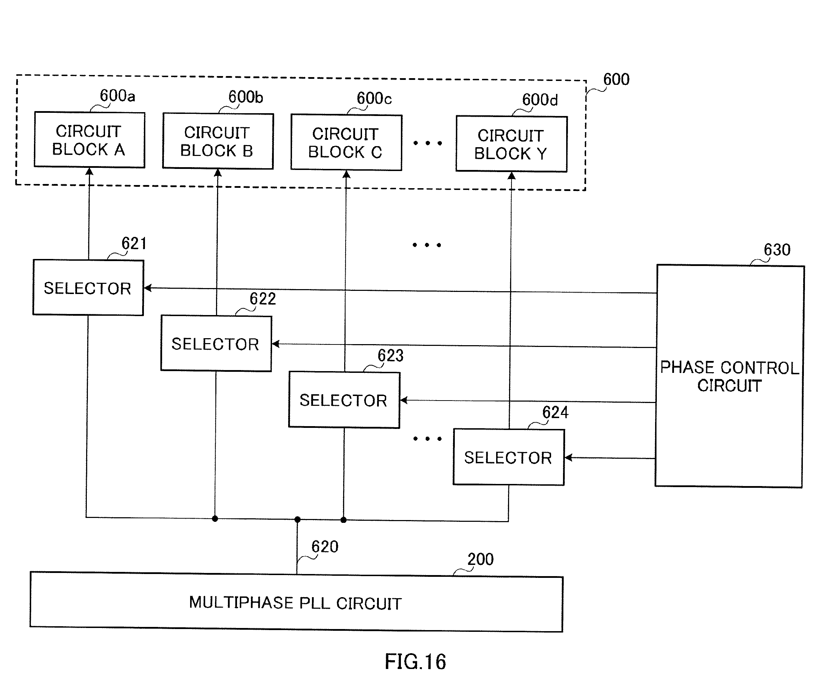

FIG.16 shows a circuit configuration of the main circuit (semiconductor apparatus 600) controlled by phase controlling section 610.

In FIG.16, semiconductor apparatus 600 has circuit blocks 600a to 600d. Circuit blocks 600a to 600d receive a supply of clock signals with a plurality of phases through selectors 621 to 624 from multiphase PLL circuit 200.

Multiphase PLL circuit 200 supplies clock signals with a plurality of phases.

Selectors 621 to 624 are subjected to switching control by phase control circuit 630.

Phase control circuit 630 receives phase control signal 611 fromphase controlling section 610 and controls selectors 621 to 624 which determine combinations of multiphase clocks for all clock signal outputs of multiphase PLL circuit 200 to be respectively supplied to circuit blocks 600a to 600d.

Hereinafter, the operation of the semiconductor apparatus configured as described above will be described. The basic operation is the same as in Embodiments 1 and 2 and repetition of description will be omitted. The characteristic operation of this embodiment will be described.

Generally, for combinations of clock phase signals supplied to circuit blocks 600a to 600d inside semiconductor apparatus 600, combinations of fixed phase signals unique to individual circuit blocks 600a to 600d are supplied such that overall semiconductor apparatus 600 operates in a regular manner, according to restrictions of transfer timings of signals of flip flops and the processing time of the combination circuit. However, when power supply voltage 131a and ground voltage 131b change, transfer timings of signals of flip flops of circuit blocks 600a to 600d and the processing time of a combination circuit change, and consequently, there is correlation between the changes in power supply voltage 131a and ground voltage 131b and the changes in combinations of phase signals of circuit blocks 600a to 600d.

To be more specific, if the potential difference between power supply voltage 131a and ground voltage 131b increases, although power consumption increases, the transfer timings of signals of the flip flops of circuit blocks 600a to 600d and the processing time of the combination circuit decrease, so that the combinations of phase signals to be supplied to circuit blocks 600a to 600d become combinations of clocks with less phase difference. On the contrary, if the potential difference between power supply voltage 131a and ground voltage 131b decreases, although power consumption decreases, the transfer timings of signals of the flip flops of circuit blocks 600a to 600d and the processing time of a combination circuit increase, so that the combinations of phase signals to be supplied to circuit blocks 600a to 600d become combinations of clocks with less phase difference.

This embodiment focuses upon this correlation and decides whether output values of sensor circuits 301a to 301g match the desired value when, in the default state of the potential difference between power supply voltage 131a and ground potential 131b, combinations of phase signals of circuit blocks 600a and 600d are provided such that this combination matches the initial value of phase control signal 611 outputted from phase controlling section 610.

If the output values match the desired value, output voltage controlling section 120 controls voltage generating section 130 such that the potential difference between power supply voltage 131a and ground voltage 131b decreases. This voltage control is repeated until immediately before output values of sensor circuits 301a to 301g become different from the desired value.

If output values do not match the desired value, phase controlling section 610 changes the combinations of phase signals to be supplied to circuit blocks 600a to 600d to combinations of clocks with greater phase difference by controlling selectors 621 and 624. If the output values of sensor circuits 301a to 301g do not match the desired value, output voltage controlling section 120 controls power supply voltage generating section 130 such that the potential difference between power supply voltage 131a and ground potential 131b increases.

The above voltage adjustment control is repeated until the output values of sensor circuits 301a to 301g become equal to the desired value or until the output values of all of sensor circuits within the range of 3σ of delay variations of sensor circuits statistically calculated from all of sensor circuits 301a to 301g by arithmetic operating section 110 become equal to the desired value.

As a result of control carried out in this way, a control code matching the final determined values of power supply voltage 131a and ground potential 131b is the value to be stored in non-volatile memory 103.

A case is assumed here as an example where the above control is implemented using an LSI tester and its program. In this case, the generated control code that is unique to semiconductor apparatus 600 is not immediately inputted to output voltage controlling section 120, and so needs to be recorded in non-volatile memory 103 on a temporary basis.

Then, when semiconductor apparatus 600 actually operates, first, a control code set to the optimum value as described above is read in output voltage controlling section 120 and phase controlling section 610 from non-volatile memory 103. Output voltage controlling section 120 controls power supply voltage generating section 130 to supply power supply voltage 131a and ground potential 131b such that power consumption is minimized when semiconductor apparatus 600 operates. Further, phase controlling section 610 controls selectors 621 to 624, so that, when phase control signal 611 is supplied to semiconductor apparatus 600, clock signals formed with combinations of phases such that semiconductor apparatus 600 having above power supply voltage 131a and ground voltage 131b operates in a regular manner, are selected and outputted to circuit blocks 600a to 600d.

As described above, according to this embodiment, a large number of sensor circuits 301a to 301g for detecting delay values are arranged evenly in individual semiconductor apparatuses 600, a control code is generated by statistically processing detection results of a large number of sensor circuits by arithmetic operating section 110, and power supply voltage 131a and ground voltage 131b can be supplied such that power consumption is minimized when semiconductor apparatus 600 operates, so that it is possible to enable both higher speed and lower power consumption taking into account local heat, IR-drop and variations in the manufacturing process at sensor circuit positions.

Although an example has been described above with this embodiment where arithmetic operating section 110, output voltage controlling section 120, power supply voltage generating section 130 and phase controlling section 610 are arranged outside semiconductor apparatus 600, part or all of these elements may be built in semiconductor apparatus 600. Further, arithmetic operating section 110 may not be necessarily an LSI tester and may be a semiconductor apparatus on a single substrate or on a single set.

Further, above Embodiments 1 to 4 provide power supply voltage generating section 130, substrate bias voltage generating section 310, clock generating section 410 and phase controlling section 610 as function blocks controlled by a control code, and employ configurations where any of these function blocks is connected with a semiconductor apparatus and supply the voltage or signals. In this case, to realize the present invention, although it is necessary to minimize power supply voltage by power supply voltage generating section 130, there are seven combinations of function blocks other than the power supply voltage generating section controlled by the above control code. Accordingly, the above embodiments are only examples, and embodiments are realized by providing combinations of function blocks other than the function blocks described in Embodiments 1 to 4.

Furthermore, Embodiments 1 to 4 may employ any circuit configuration of FIG.2, FIG.12 or FIG.14.

Above Embodiments 1 to 4 are aspects that provide non-volatile memory 103 which stores an output result of arithmetic operating section 110 in a semiconductor apparatus on a temporarybasis. However, with the present invention, it is also possible to directly supply statistical processing results of sensor circuits to controlling sections without carrying out recording and reading in/from non-volatile memory 103. Hereinafter, cases will be described with Embodiments 5 to 8 where statistical processing results of sensor circuits are directly supplied to controlling sections without using a memory such as a non-volatile memory. By directly outputting statistical processing results of sensor circuits without using a memory, it is possible to carry out continued feedback control and follow time changes of states such as temperature variations.

### (Embodiment 5)

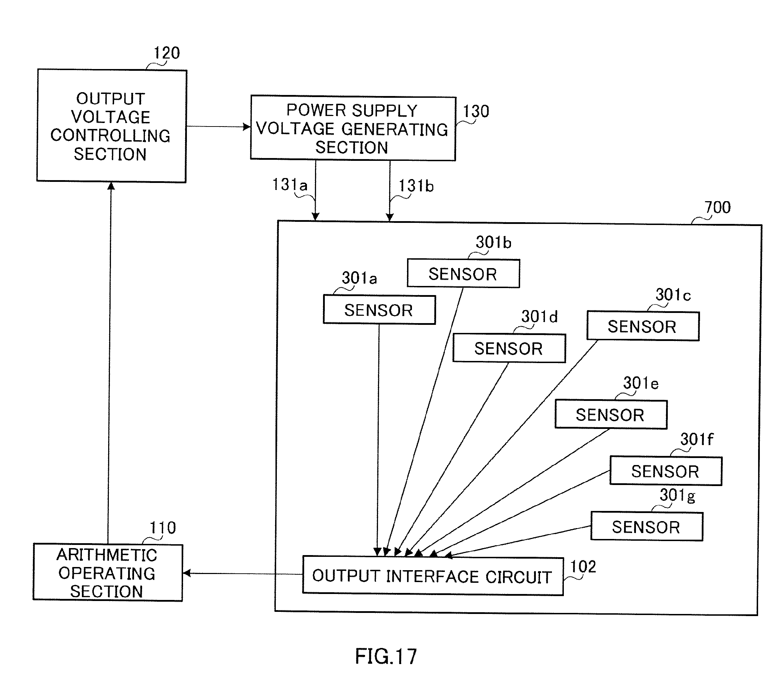

FIG.17 is a circuit block diagram showing a configuration of a semiconductor apparatus according to Embodiment 5 of the present invention. This embodiment provides an example of applying the present invention to a semiconductor integrated circuit that applies sensor cirucits of Embodiment 2, that reflects an arithmetic operation result obtained by statistically processing sensor circuit outputs without using a memory, to power supply voltage and that realizes continued feedback control. The same elements as in FIG.10 are assigned the same reference numerals and overlapping description will be omitted.

In FIG.17, the function blocks of the semiconductor apparatus are configured with: semiconductor apparatus 700; arithmetic operating section 110 which statistically processes detected delay information and generates a control code by judging conditions such as variations in the manufacturing process; output voltage controlling section 120 which determines the voltage to be outputted based on the recorded control code; and power supply voltage generating section 130 which supplies power supply voltage 131a and ground potential 131b to semiconductor apparatus 700.

Semiconductor apparatus 700 has a plurality of sensor circuits 301a to 301g arranged evenly inside semiconductor apparatus 700 to detect delay values and output interface circuit 102 which collects delay information detected by a plurality of sensor circuits 301a to 301g and outputs the collected information to outside.

In semiconductor apparatus 700, non-volatile memory 103 is not provided and statistical processing results of sensor circuits 301a to 301g from output interface circuit 102 are directly outputted to arithmetic operating section 110.

Semiconductor apparatus 700 is the main circuit which has at least one MOS transistor and operates by receiving a supply of power supply voltage.

A plurality of sensor circuits 301a to 301g are built in semiconductor apparatus 700 and detect a plurality of items of delay information taking into account their respective positions and operation conditions.

Output interface circuit 102 collects output results of a plurality of sensor circuits 301a to 301g and outputs the collected results to arithmetic operating section 110.

Arithmetic operating section 110 operates the output results of a plurality of sensor circuits 301a to 301g outputted from output interface circuit 102.

Output voltage controlling section 120 controls the output voltage according to the output result of arithmetic operating section 110.

Power supply voltage generating section 130 supplies power supply voltage to semiconductor apparatus 700 according to the control of output voltage controlling section 120.

Similar to Embodiment 1 to 4, features of this embodiment include (1) making sensor circuits 301a to 301g for detecting delay values in different configurations from conventional sensor circuits, (2) arranging a large number of sensor circuits 301a to 301g evenly in semiconductor apparatus 700, and (3) generating a control code by statistically processing detection results of a large number of sensor circuits 301a to 301g by arithmetic operating section 110.

The detailed example is described with reference to above FIG.6 to FIG.8 where a large number of sensor circuits 301a to 301g of above (2) are arranged evenly in semiconductor apparatus 700.

Hereinafter, the operation of the semiconductor apparatus configured as described above will be described. The basic operation is the same as in Embodiments 1 and 2.

Output values of sensor circuits 301a to 301g are compared with the desired value and inputted to arithmetic operating section 110 through output interface circuit 102 as detection results.

Arithmetic operating section 110 statistically processes the maximum value, minimum value and distribution of detected delay information, and generates a control code as a statistical processing result.

The generated control code is read by output voltage controlling section 120, and output voltage controlling section 120 controls power supply voltage generating section 130 to supply power supply voltage 131a and ground potential 131b such that power consumption is minimized when semiconductor apparatus 700 operates.

As described above, with this embodiment, a large number of sensor circuits 301a to 301g for detecting delay values are arranged evenly in individual semiconductor apparatuses 700, a control code is generated by statistically processing detection results of a large number of sensor circuits, and power supply voltage 131a and ground voltage 131b can be supplied such that power consumption is minimized when semiconductor apparatus 700 operates, so that it is possible to enable both higher speed and lower power consumption, taking into account local heat, IR-drop and variations in the manufacturing process at each position of the sensor circuits.

Particularly, with this embodiment, statistical processing results of sensor circuits 301a to 301g are directly outputted to arithmetic operating section 110 without using non-volatile memory 103, so that it is possible to carry out continued feedback control and follow time changes of conditions such as temperature variations. That is, statistical processing results of sensor circuits 301a to 301g are outputted at the real time, so that it is possible to continuously follow changes in temperature in semiconductor apparatus 700. Further, one reason for using a memory such as non-volatile memory 103 is to use fixed data. However, when temperature in semiconductor apparatus 700 changes, the significance of using the above fixed data is less. According to this embodiment, by directly outputting statistical processing results of sensor circuits 301a to 301g, it is possible to realize continued feedback control and follow time changes of conditions such as temperature variations.

Although an example has been described above with this embodiment where arithmetic operating section 110, output voltage controlling section 120 and power supply voltage generating section 130 are arranged outside semiconductor apparatus 700, part or all of these elements may be built in semiconductor apparatus 700 and may be a semiconductor apparatus on a single substrate or on a single set.

Furthermore, sensor circuits of this embodiment may employ any circuit configuration of FIG.2, FIG.12 or FIG.14.

### (Embodiment 6)

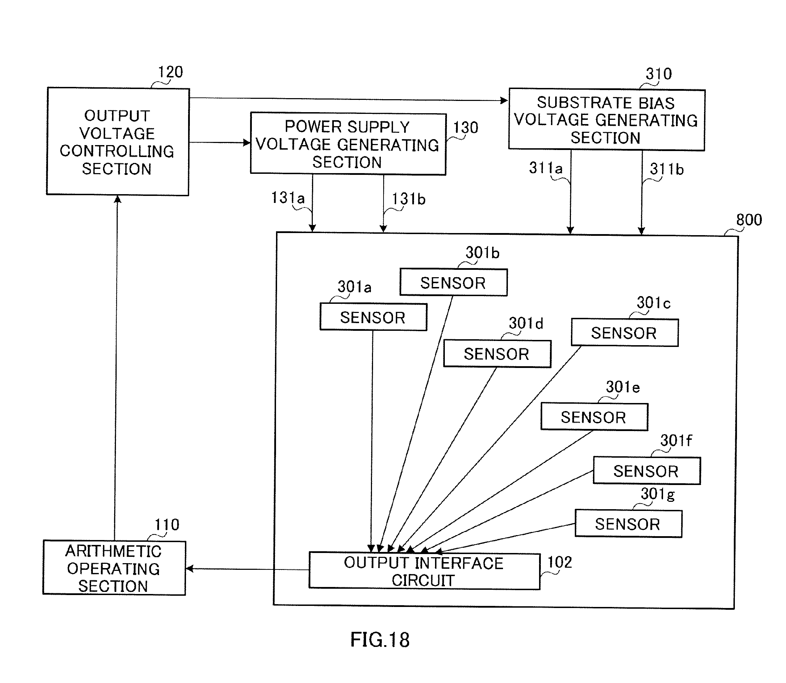

FIG.18 is a circuit block diagram showing a configuration of a semiconductor apparatus according to Embodiment 6 of the present invention. This embodiment provides an example of applying the present invention to a semiconductor integrated circuit that applies sensor circuits of Embodiment 2, that reflects an arithmetic operation result obtained by statistically processing sensor circuit outputs without using a memory, in power supply voltage and substrate bias voltage, and that realizes continued feedback control. The same elements as in FIG.10 will be assigned the same reference numerals and overlapping description will be omitted.

In FIG. 18, the function blocks of the semiconductor apparatus are configured with: semiconductor apparatus 800; arithmetic operating section 110 which statistically processes detected delay information and generates a control code by judging conditions such as variations in the manufacturing process; output voltage controlling section 120 which determines the voltage to be outputted based on the recorded control code; power supply voltage generating section 130 which supplies power supply voltage 131a and ground potential 131b to semiconductor apparatus 800; and substrate bias voltage generating section 310 which supplies PMOS transistor substrate bias voltage 311a and NMOS transistor substrate bias voltage 311b to semiconductor apparatus 800.

Semiconductor apparatus 800 has a plurality of sensor circuits 301a to 301g arranged evenly inside semiconductor apparatus 800 to detect delay values, and output interface circuit 102 which collects delay information detected by a plurality of sensor circuits 301a to 301g and outputs the collected information to outside.

Semiconductor apparatus 800 is a main circuit configured with at least one MOS transistor. A plurality of sensor circuits 301a to 301g are built in semiconductor apparatus 800 and detect a plurality of items of delay information taking into account their respective positions and operation conditions.

Output interface circuit 102 collects output results of a plurality of sensor circuits 301a to 301g and outputs the collected results to arithmetic operating section 110.

Arithmetic operating section 110 operates the output results of a plurality of sensor circuits 301a to 301g outputted from output interface circuit 102.

Output voltage controlling section 120 controls the output voltage according to the output result of arithmetic operating section 110.

Power supply voltage generating section 130 supplies power supply voltage to semiconductor apparatus 800 according to the control of output voltage controlling section 120.

Substrate bias voltage generating section 310 supplies the substrate potential of the P-channel MOS transistor and the substrate potential of the N-channel MOS transistor to the main circuit (semiconductor apparatus 800), according to the control of output voltage controlling section 120. Substrate bias voltage generating section 310 is able to individually control the substrate potential of the P-channel MOS transistor and the substrate potential of the N-channel MOS transistor, according to operation performance required for the whole of the main circuit and the overall circuit condition of the main circuit.

Hereinafter, the operation of the semiconductor apparatus configured as described above will be described. The basic operation is the same as in Embodiments 1 and 2.

Output values of sensor circuits 301a to 301g are compared with the desired value and inputted to arithmetic operating section 110 through output interface circuit 102 as the detection results.

Arithmetic operating section 110 statistically processes the maximum value, minimum value and distribution of detected delay information, and generates a control code as a statistical processing result.

The generated control code is read by output voltage controlling section 120. Output voltage controlling section 120 controls substrate bias voltage generating section 310 to supply PMOS transistor substrate bias voltage 311a and NMOS transistor substrate bias voltage 311b such that threshold voltages for the PMOS transistor and the NMOS transistor decrease. However, if the threshold for the MOS transistor goes below a given value, leakage current increases and power consumption increases, so that the lower limit voltage and the upper limit voltage are set for PMOS transistor substrate bias voltage 311a and substrate bias voltage 311b in advance, respectively.

In this way, when leakage current is within an allowable range and when the threshold voltage of each transistor becomes extremely small, output voltage controlling section 120 controls power supply voltage generating section 130 to supply power supply voltage 131a and groundpotential 131b such that power consumption is minimized when semiconductor apparatus 800 operates.

As described above, with this embodiment, a large number of sensor circuits 301a to 301g for detecting delay values are arranged evenly in individual semiconductor apparatuses 800, a control codes is generated by statistically processing detection results of a large number of sensor circuits in arithmetic operating section 110, and power supply voltage 131a and ground voltage 131b can be supplied such that power consumption is minimized when semiconductor apparatus 800 operates, so that it is possible to enable both higher speed and lower power consumption, taking into account local heat, IR-drop and variations in the manufacturing process at each position of the sensor circuits.

Similar to Embodiment 5, with this embodiment, statistical processing results of sensor circuits 301a to 301g are directly outputted to arithmetic operating section 110 without using non-volatile memory 103, so that it is possible to carry out continued feedback control and follow time changes of conditions such as temperature variations.

Further, although an example has been described above with this embodiment where arithmetic operating section 110, output voltage controlling section 120, power supply voltage generating section 130 and substrate bias voltage generating section 310 are arranged outside semiconductor apparatus 800, part or all of these elements may be built in semiconductor apparatus 800 and may be a semiconductor apparatus on a single substrate or on a single set.

Furthermore, sensor circuits of this embodiment may employ any circuit configuration of FIG.2, FIG.12 or FIG.14.

### (Embodiment 7)

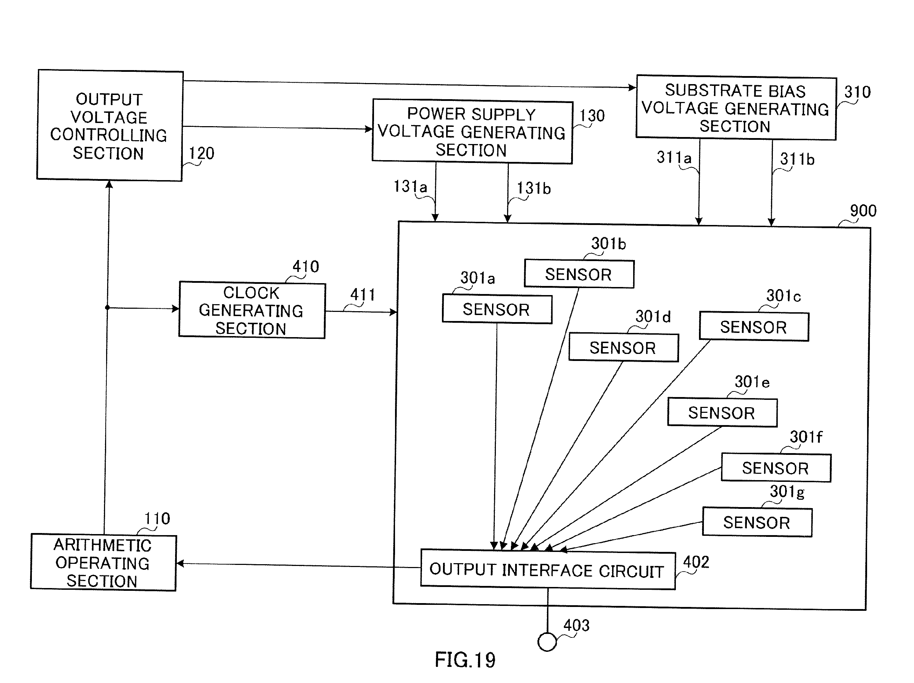

FIG.19 is a circuit block diagram showing a configuration of a semiconductor apparatus according to Embodiment 7 of the present invention. This embodiment provides an example of applying the present invention to a semiconductor integrated circuit that applies sensor circuits of Embodiment 2, that reflects an arithmetic operation result obtained by statistically processing sensor circuit outputs without using a memory, in power supply voltage and substrate bias voltage, and that realizes continued feedback control. The same elements as in FIG. 10 and FIG. 13 will be assigned the same reference numerals and overlapping description will be omitted.

In FIG. 19, the function blocks of the semiconductor apparatus are configured with: semiconductor apparatus 900; arithmetic operating section 110 which statistically processes detected delay information and generates a control code by judging conditions such as variations in the manufacturing process; output voltage controlling section 120 which determines the voltage to be outputted based on the recorded control code; power supply voltage generating section 130 which supplies power supply voltage 131a and ground potential 131b to semiconductor apparatus 900; and substrate bias voltage generating section 310 which supplies PMOS transistor substrate bias voltage 311a and NMOS transistor substrate bias voltage 311b to semiconductor apparatus 900; clock generating section 410 which supplies operation clock signal 411 to semiconductor apparatus 900; and mode setting terminal 403 which controls the operation mode of semiconductor apparatus 900 from outside.

Semiconductor apparatus 900 has a plurality of sensor circuits 301a to 301g arranged evenly inside semiconductor apparatus 900 to detect delay values and output interface circuit 402 which collects delay information detected by a plurality of sensor circuits 301a to 301g and outputs the collected information to outside.

Semiconductor apparatus 900 is a main circuit which has at least one MOS transistor and operates by receiving a supply of power supply voltage.

A plurality of sensor circuits 301a to 301g are built in semiconductor apparatus 900 and detect a plurality of items of delay information taking into account their respective positions and operation conditions.

Output interface circuit 402 is connected with mode setting terminal 403 for controlling the operation mode of semiconductor apparatus 900 from outside, collects output results of a plurality of sensor circuits 301a to 301g and outputs the collected results to arithmetic operating section 110.

Arithmetic operating section 110 operates the output results of a plurality of sensor circuits 301a to 301g outputted from output interface circuit 402.

Output voltage controlling section 120 controls the output voltage according to the output result of arithmetic operating section 110.

Power supply voltage generating section 130 supplies power supply voltage to semiconductor apparatus 900 according to the control of output voltage controlling section 120.

Substrate bias voltage generating section 310 supplies the substrate potential of the P-channel MOS transistor and the substrate potential of the N-channel MOS transistor to the main circuit (semiconductor apparatus 900), according to the control of output voltage controlling section 120. Substrate bias voltage generating section 310 is able to individually control the substrate potential of the P-channel MOS transistor and the substrate potential of the N-channel MOS transistor, according to operation performance required for the whole of the main circuit and the overall circuit condition of the main circuit.

Clock generating section 410 supplies a clock signal to a main circuit (semiconductor apparatus 900) according to the output result of arithmetic operating section 110. Clock generating section 410 is able to individually control clock signals according to operation performance required for the whole of the main circuit and the overall circuit condition of the main circuit.

Hereinafter, the operation of the semiconductor apparatus configured as described above will be described. The basic operation is the same as in Embodiments 2 and 3.

Generally, a unique fixed value is set for the clock frequency supplied to semiconductor apparatus 900 according to restrictions of timings or processing times of systems integrated in semiconductor apparatus 900. Further, generally, it is possible to extend the processing time or pause the processing, depending on the setting condition of mode setting terminal 403. A case is described with this embodiment as an example where, depending on the setting condition of mode setting terminal 403, when an extension of processing time or a pause is commanded in addition to normal operation, PMOS transistor substrate bias voltage 311a and NMOS transistor substrate bias voltage 311b, and power supply voltage 131a and ground potential 131b are supplied optimally, so that it is possible to enable higher speed and lower power consumption.

In the normal operation mode, clock generating section 410 supplies operation clock signal 411 of the frequency determined in advance by system requirement. This operation clock signal 411 is inputted to sensor circuits 301a to 301g.

Sensor circuits 301a to 301g send out output values reflecting actual clock requirement, substrate bias voltage and power supply voltage, to output interface circuit 402.

When output values of sensor circuits match the desired output signal, output voltage controlling section 120 controls substrate bias voltage generating section 310 to supply PMOS transistor substrate bias voltage 311a and NMOS transistor substrate bias voltage 311b such that threshold voltages for the PMOS transistor and the NMOS transistor decrease. However, if the threshold for the MOS transistor goes below a given value, leakage current increases and then power consumption increases, so that the lower limit voltage and the upper limit voltage are set for PMOS transistor substrate bias voltage 311a and substrate bias voltage 311b in advance, respectively.

In this way, when leakage current is within an allowable range and when the threshold voltage of each transistor becomes extremely small, output voltage controlling section 120 controls power supply voltage generating section 130 to supply power supply voltage 131a and ground potential 131b such that power consumption is minimized when semiconductor apparatus 900 operates.

When output values of sensor circuits do not match the desired output signal, output voltage controlling section 120 controls substrate bias voltage generating section 310 to supply PMOS transistor substrate bias voltage 311a and NMOS transistor substrate bias voltage 311b such that threshold voltages for the PMOS transistor and the NMOS transistor decrease. However, if the threshold for the MOS transistor goes below a given value, leakage current increases and then power consumption increases, so that the lower limit voltage and the upper limit voltage are set for PMOS transistor substrate bias voltage 311a and substrate bias voltage 311b in advance, respectively.

In this way, when leakage current is within an allowable range, when the threshold voltage of each transistor becomes extremely small and when, still, output values of sensor circuits do not match the desired output signal, output voltage controlling section 120 controls power supply voltage generating section 130 to supply power supply voltage 131a and ground potential 131b such that the potential difference between the voltages increases. Adjustment based on feedback of power supply voltage 131a and ground potential 131b is repeated until the output values of sensor circuits match the desired output signal.

Although the above description focuses upon normal operation mode, when the setting condition of mode setting terminal 403 shows an extension of processing time, the frequency of operation clock signal 411 of clock generating section 410 is decreased based on mode requirement, and a control codes is set so that the difference between power supply voltage 131a and ground potential 131b becomes less compared to the case of the normal operation mode.

When the setting condition of mode setting terminal 403 shows a pause, the frequency of operation clock signal 411 of clock generating section 410 is stopped (that is, fixed). Next, output voltage controlling section 120 controls substrate bias voltage generating section 310 such that substrate bias voltage 311a increases greater than the source voltage of the PMOS transistor and NMOS transistor substrate bias voltage 311b decreases less than the source voltage of the NMOS transistor, so that the threshold voltages of the PMOS transistor and NMOS transistor increase and leakage current is minimized. Finally, output voltage controlling section 120 carries out control such that the difference between power supply voltage 131a and ground potential 131b is lowered to the potential difference where an internal signal condition does not change due to leakage or noise.

As described above, with this embodiment, a large number of sensor circuits 301a to 301g for detecting delay values are arranged evenly in individual semiconductor apparatuses 900, a control code is generated by statistically processing detection results of a large number of sensor circuits by reflecting the setting condition of mode setting terminal 403, power supply voltage 131a and ground voltage 131b, and PMOS transistor substrate bias voltage 311a and NMOS transistor substrate bias voltage 311b can be supplied such that power consumption is minimized when semiconductor apparatus 900 operates, so that it is possible to enable both higher speed and lower power consumption taking into account local heat, IR-drop and variations in the manufacturing process at each position of the sensor circuits.

Further, similar to Embodiments 5 and 6, with this embodiment, statistical processing results of sensor circuits 301a to 301g are directly outputted to arithmetic operating section 110 without using non-volatile memory 103, so that it is possible to carry out continued feedback control and follow time changes of conditions such as temperature variations.

Although an example has been described above with this embodiment where arithmetic operating section 110, output voltage controlling section 120, power supply voltage generating section 130, substrate bias voltage generating section 310 and clock generating section 410 are arranged outside semiconductor apparatus 900, part or all of these elements may be built in semiconductor apparatus 900 and may be a semiconductor apparatus on a single substrate or on a single set.

Furthermore, sensor circuits of this embodiment may employ any circuit configuration of FIG.2, FIG.12 or FIG.14.

### (Embodiment 8)

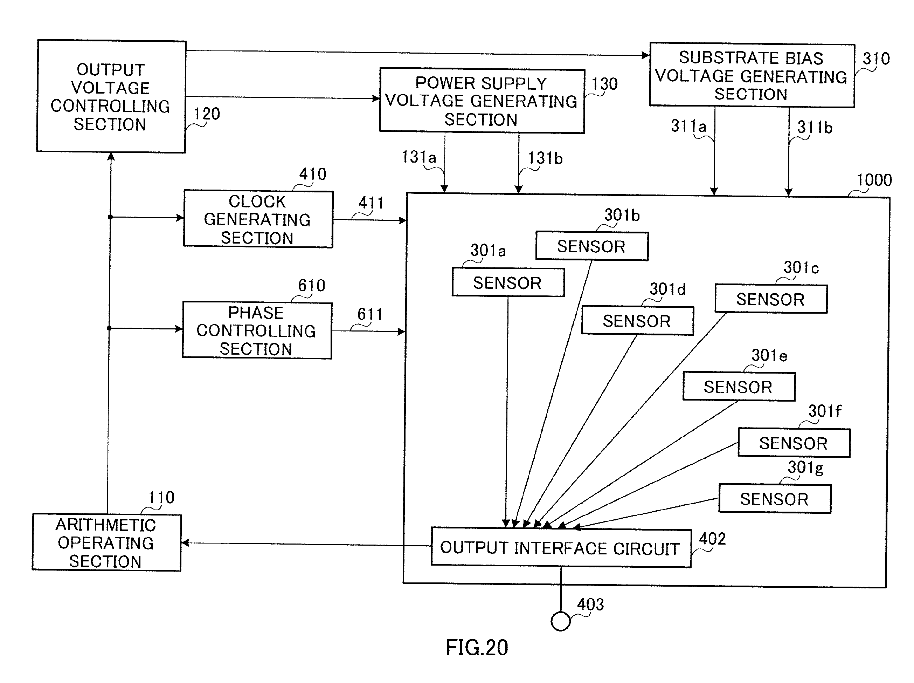

FIG.20 is a circuit block diagram showing a configuration of a semiconductor apparatus according to Embodiment 8 of the present invention. This embodiment provides an example of applying the present invention to a semiconductor integrated circuit that applies sensor circuits of Embodiment 2, that reflects an arithmetic operation result obtained by statistically processing sensor circuit outputs without using a memory, in power supply voltage, substrate bias voltage, clock frequency and clock phase, and that realizes continued feedback control. The same elements as in FIG.10, FIG.13 and FIG.15 will be assigned the same reference numerals and overlapping description will be omitted.

In FIG.20, the function blocks of the semiconductor apparatus are configured with: semiconductor apparatus 1000; arithmetic operating section 110 which statistically processes detected delay information and generates a control code by judging conditions such as variations in the manufacturing process; output voltage controlling section 120 which determines the voltage to be outputted based on the recorded control code; power supply voltage generating section 130 which supplies power supply voltage 131a and ground potential 131b to semiconductor apparatus 1000; substrate bias voltage generating section 310 which supplies PMOS transistor substrate bias voltage 311a and NMOS transistor substrate bias voltage 311b to semiconductor apparatus 1000; clock generating section 410 which supplies operation clock signal 411 to semiconductor apparatus 1000; phase controlling section 610 which controls the clock phase supplied to semiconductor apparatus 1000; and mode setting terminal 403 which controls the operation mode of semiconductor apparatus 1000 from outside.

Semiconductor apparatus 1000 has a plurality of sensor circuits 301a to 301g arranged evenly inside semiconductor apparatus 1000 to detect delay values, and output interface circuit 402 which collects delay information detected by a plurality of sensor circuits 301a to 301g and outputs the collected information to outside.

Semiconductor apparatus 1000 is a main circuit which has at least one MOS transistor and operates by receiving a supply of power supply voltage.

A plurality of sensor circuits 301a to 301g are built in semiconductor apparatus 1000 and detect a plurality of items of delay information taking into account their respective positions and operation conditions.

Output interface circuit 402 is connected with mode setting terminal 403 for controlling the operation mode of semiconductor apparatus 1000 from outside, collects output results of a plurality of sensor circuits 301a to 301g and outputs the collected results to arithmetic operating section 110.

Arithmetic operating section 110 operates the output results of a plurality of sensor circuits 301a to 301g outputted from output interface circuit 402.

Output voltage controlling section 120 controls the output voltage according to the output result of arithmetic operating section 110.

Power supply voltage generating section 130 supplies power supply voltage to semiconductor apparatus 1000 according to the control of output voltage controlling section 120.

Substrate bias voltage generating section 310 supplies the substrate potential of the P-channel MOS transistor and the substrate potential of the N-channel MOS transistor to the main circuit (semiconductor apparatus 1000), according to the control of output voltage controlling section 120. Substrate bias voltage generating section 310 is able to individually control the substrate potential of the P-channel MOS transistor and the substrate potential of the N-channel MOS transistor, according to operation performance required for the whole of the main circuit and the overall circuit condition of the main circuit.

Clock generating section 410 supplies a clock signal to a main circuit (semiconductor apparatus 1000) according to the output result of arithmetic operating section 110. Clock generating section 410 is able to individually control clock signals according to operation performance required for the whole of the main circuit and the overall circuit condition of the main circuit.

Phase controlling section 610 supplies phase control signal 611 to the main circuit (semiconductor apparatus 1000), according to the control of output result of arithmetic operating section 110. Phase controlling section 610 includes a phase controlling section and is able to individually control phase control signals according to operation performance required for the whole of the main circuit and the overall circuit condition of the main circuit.

Hereinafter, the operation of the semiconductor apparatus configured as described above will be described. The basic operation is the same as in Embodiments 2 and 3.

FIG.14 shows a detailed configuration of the real circuit where the sensor circuits 301a to 301g are arranged.

Further, FIG.16 shows a circuit configuration of the main circuit (semiconductor apparatus 1000) controlled by phase controlling section 610.

In FIG.16, the semiconductor apparatus has circuit blocks 600a to 600d. Circuit blocks 600a to 600d receive a supply of clock signals with a plurality of phases through selectors 621 to 624 from multiphase PLL circuit 200.

Multiphase PLL circuit 200 supplies clock signals with a plurality of phases.

Selectors 621 to 624 are subjected to switching control by phase control circuit 630.

Phase control circuit 630 receives phase control signal 611 fromphase controlling section 610 and controls selectors 621 to 624 which determine combinations of multiphase clocks for all clock signal outputs of multiphase PLL circuit 200 to be respectively supplied to circuit blocks 600a to 600d.

Further, a clock signal inputted from clock input terminal 501 (refer to FIG.14) is supplied by clock generating section 410.

Generally, a unique fixed value is set for the clock frequency supplied to semiconductor apparatus 1000 according to restrictions of timings or processing times of systems integrated in semiconductor apparatus 1000. Further, generally, it is possible to extend the processing time or pause the processing, depending on the setting condition of mode setting terminal 403. A case is described with this embodiment as an example where, depending on the setting condition of mode setting terminal 403, when an extension of processing time or a pause is commanded in addition to normal operation, power supply voltage 131a and ground potential 131b are supplied optimally, so that it is possible to enable higher speed and lower power consumption.

In the normal operation mode, clock generating section 410 supplies operation clock signal 411 of the frequency determined in advance by system requirement. This operation clock signal 411 is inputted to clock input terminal 501 (FIG.14) of sensor circuits 301a to 301g.

For example, if the test signal outputted from test signal generating section 502 is a rising pulse signal that changes from low to high, combination circuit 503 carries out signal input, operation processing and output at the timing specified by the frequency of operation clock signal 411. However, when power supply voltage is not sufficient and the capability of the MOS transistor decreases due to variations in the manufacturing process, IR-drop and local heating, the desired output signal cannot be obtained.

In this case, first, substrate bias voltage generating section 310 supplies voltages such that PMOS transistor substrate bias voltage 311a decreases and NMOS transistor substrate bias voltage 311b increases based on a given limitation set based on the condition of the leakage current, so that the threshold voltages of the PMOS transistor and the NMOS transistor of semiconductor apparatus 1000 lower.

Phase control signal 611 is inputted to phase controlling section 610. Phase control circuit 630 receives phase control signal 611 from phase controlling section 610 and controls selectors 621 to 624 which determine combinations of multiphase clocks for all clock signal outputs of multiphase PLL circuit 200 to be respectively supplied to circuit blocks 600a to 600d, such that the potential difference between multiphase clocks supplied to each circuit block increases.

Even when outputs of sensor circuits 301a to 301g satisfying the desired value cannot be obtained at this stage, output voltage controlling section 130 controls semiconductor apparatus 1000 to supply power supply voltage 131a and ground potential 131b such that the potential difference between the voltages increases.

This series of feedback control is repeated until the outputs matching the desired value can be obtained from sensor circuits 301a to 301g and, consequently, it is possible to realize semiconductor apparatus 1000 that enables higher speed and lower power consumption in the normal operation mode.

Although the above description focuses upon normal operation mode, when the setting condition of mode setting terminal 403 shows an extension of processing time, the frequency of operation clock signal 411 of clock generating section 410 and the clock frequency inputted to clock input terminal 501 are decreased based on mode requirement, and a control code is set, so that the difference between power supply voltage 131a and ground potential 131b becomes less compared to the case of the normal operation mode.

When the setting condition of mode setting terminal 403 shows a pause, the frequency of operation clock signal 411 of clock generating section 410 and the clock frequency inputted to clock input terminal 501 stop (that is, fix), operation of multiphase PLL circuit 200 stops, PMOS transistor substrate bias voltage 311a increases more than the source voltage of the PMOS transistor, NMOS transistor substrate bias voltage 311b decreases less than the source voltage of the NMOS transistor and control is carried out such that the leakage current reduces. Further, the difference between power supply voltage 131a and ground potential 131b is lowered to the potential difference where an internal signal condition does not change due to leakage or noise.

As described above, with this embodiment, a large number of sensor circuits 301a to 301g for detecting delay values are arranged evenly in individual semiconductor apparatuses 1000, a control code is generated by statistically processing detection results of a large number of sensor circuits, and power supply voltage 131a and ground voltage 131b can be supplied such that power consumption is minimized when semiconductor apparatus 400 operates, so that it is possible to enable both higher speed and lower power consumption taking into account local heat, IR-drop and variations in the manufacturing process at each position of the sensor circuits.

Similar to Embodiments 5 to 7, with this embodiment, statistical processing results of sensor circuits 301a to 301g are directly outputted to arithmetic operating section 110 without using non-volatile memory 103, so that it is possible to carry out continued feedback control and follow time changes of conditions such as temperature variations.

Further, although an example has been described above with this embodiment where arithmetic operating section 110, output voltage controlling section 120, power supply voltage generating section 130, substrate bias voltage generating section 310, clock generating section 410 and phase controlling section 610 are arranged outside semiconductor apparatus 1000, part or all of these elements may be built in semiconductor apparatus 1000 and may be a semiconductor apparatus on a single substrate or on a single set.

Furthermore, sensor circuits of this embodiment may employ any circuit configuration of FIG.2, FIG.12 or FIG.14.

Above description illustrates preferable embodiments and the scope of the present invention is not limited to these.

For example, above Embodiments 1 to 4 provide a power supply voltage generating section, a substrate bias voltage generating section, a clock generating section and a phase controlling section as function blocks controlled by a control code, and employ configurations where any of these function blocks is connected with a semiconductor apparatus and supply the voltage or signals. In this case, to realize the present invention, although it is necessary to minimize power supply voltage by the power supply voltage generating section, there are seven combinations of function blocks other than the power supply voltage generating section controlled by the above control code. Accordingly, Embodiments 1 to 4 are only examples, and embodiments are realized by providing combinations of function blocks other than the function blocks described in detail in Embodiments 5 to 8.

Further, delay information may be statistically processed using an external apparatus such as an LSI tester upon quality inspection, and processing functions such as a majority circuit and maximum value extraction circuit may be built in the semiconductor apparatus. Furthermore, the statistical processing result of delay information may be directly transferred to a controlling means or may be supplied to the controlling means by storing the result in a memory apparatus on a temporary basis and reading the value from the memory apparatus. Still further, any control means may be employed that carries out control using one of or in combination of power supply voltage, operation frequency and substrate bias voltage.

Although the phrase "semiconductor apparatus" has been used with the above embodiments for ease of explanation, other phrases such as "semiconductor integratedcircuit"and"powersupplyvoltagecontrolling apparatus" may be used.

Moreover, the types, the number and connection methods of circuit sections such as sensor circuits and buffer circuits forming the above semiconductor apparatus are not limited to the above embodiments.

As described above, according to the present invention, by statistically processing delay information obtained by dozens or several hundreds of sensor circuits arranged evenly inside a semiconductor apparatus, it is possible to prevent miss detection as to local characteristic variations upon design, and, by actually arranging sensor circuits at locations, it is possible to accurately measure characteristic variations due to IR-drop, local heating, circuit sensor directions and positions, so that it is possible to enable both higher speed and lower power consumption, which usually show a trade-off relationship, to improve the performance of the semiconductor apparatus using the MOS transistor. Further, detection accuracy of sensor circuits built in a semiconductor apparatus and fidelity to the real circuit are improved, and a large number of sensor circuits are arranged evenly in the semiconductor apparatus and sensor outputs are statistically processed, so that it is possible to detect the condition reflecting local characteristic variations. By reflecting and carrying out feedback control of this condition detection result in power supply voltage, substrate bias voltage, clock frequency and clock phase, it is possible to enable high speed and low power consumption in individual semiconductor apparatuses. Further, by recording the optimum condition in a non-volatile memory as a control code, it is possible to enable high speed and low power consumption without feedback loop.

Accordingly, the semiconductor apparatus according to the present invention having a circuit configuration providing sensor circuits, an arithmetic operation circuit for carrying out statistical processing and a controlling circuit, is not limited to a semiconductor apparatus arranged on a single substrate by CMOS process and bipolar process and may be realized in flexible configurations based on purposes of use or limitation. For example, respective functions may be shared in separate semiconductor apparatuses according to the goal such that manufacturing costs becomes the cheapest, respective functions may be integrated in a small number of semiconductor apparatuses according to the goal such that the semiconductor apparatuses made smaller or statistical processing function may be shared in a DSP circuit on a single set forming a product, an external detecting apparatus and an external arithmetic operating apparatus which communicates information.

The present invention is not limited to the above described embodiments, and various variations and modifications may be possible without departing from the scope of the present invention.

The disclosure of Japanese Patent Application No.2006-326339, filed on December 1, 2006, including the specification, drawings and abstract, is incorporated herein by reference in its entirety.

## Claims

1. A semiconductor apparatus comprising:
a main circuit (100) that includes at least one metal oxide semiconductor transistor and operates by receiving a supply of power supply voltage;
a plurality of sensor circuits (101a-101g) that are arranged in the main circuit(100) and detect local characteristic variations at each position of the sensor circuits(101a-101g) as delay information;
an output interface circuit(102) that collects detection results of the plurality of sensor circuits (101a-101g) and outputs the collected results;
an arithmetic operating section(110) that statistically processes the detection results of the plurality of sensor circuits (101a-101g) outputted from the output interface circuit(102);
a power supply voltage controlling section(130) that controls the power supply voltage supplied to the main circuit(100), based on the arithmetic operation result of the arithmetic operating section(110).

2. The semiconductor apparatus according to claim 1, wherein a large number of the sensor circuits are arranged evenly in the main circuit.

3. The semiconductor apparatus according to claim 1, wherein the plurality of sensor circuits are arranged evenly near a central processing unit, a processor including a digital signal processor, or a bus.

4. The semiconductor apparatus according to claim 1, wherein the plurality of sensor circuits are arranged evenly at positions in the main circuit where temperature rises and large current occurs.

5. The semiconductor apparatus according to claim 1, wherein the plurality of sensor circuits are arranged evenly by area matrix division and random arrangement.

6. The semiconductor apparatus according to claim 1, wherein the sensor circuits comprise:
a plurality of buffer chain circuits comprised of a plurality of buffer circuits of different capabilities;
a first flip flop circuit with a data output terminal connected with a common input terminal of the plurality of buffer chain circuits;
a test signal generating circuit that has an output terminal connected with the data input terminal of the first flip flop circuit and generates a test signal;
a plurality of flip flop circuits with data input terminals connected with output terminals of the plurality of buffer chain circuits; and
a decoder circuit that is connected with the output terminals of the plurality of flip flop circuits and calculates a delay time difference between outputs of the plurality of buffer chain circuits.

7. The semiconductor apparatus according to claim 6, wherein the buffer circuits comprise:
a first positive metal oxide semiconductor transistor with a gate terminal connected with an input terminal;
a negative metal oxide semiconductor that has a gate terminal to which a first direct current bias voltage is applied and a drain terminal connected with a drain terminal of the first positive metal oxide semiconductor;
a first inverter circuit with an input terminal connected with the drain terminal of the first positive metal oxide semiconductor transistor and the drain terminal of the first negative metal oxide semiconductor transistor;
a second negative metal oxide semiconductor transistor with a gate terminal connected with an output terminal of the first inverter circuit;
a second positive metal oxide semiconductor transistor that has a gate terminal to which a second direct current bias voltage is applied and has a drain terminal connected with a drain terminal of the second negative metal oxide semiconductor transistor;
a second inverter circuit with an input terminal connected with the drain terminal of the second negative metal oxide semiconductor transistor and the drain terminal of the second positive metal oxide semiconductor transistor; and
an output terminal that outputs an output from the second inverter circuit as an output from the buffer circuit.

8. The semiconductor apparatus according to claim 6, further comprising a multiphase phase locked loop circuit that generates multiphase clocks of random varying phases,
wherein the multiphase phase locked loop circuit supplies the generated multiphase clocks with varying phases to the first flip flop circuit and the plurality of flip flop circuits as clock signals.

9. The semiconductor apparatus according to claim 8,
wherein the multiphase phase locked loop circuit comprises:
a selector that selects a plurality of clocks with varying phases of the multiphase phase locked loop circuit according to a phase control signal and supplies the plurality of clocks with varying phases to circuit blocks of the main circuit; and
a phase control circuit that controls selection of the plurality of clocks with varying phases according to the phase control signal.

10. The semiconductor apparatus according to claim 1,
wherein the sensor circuits comprise:
a combination circuit;
a second flip flop with a data output terminal connected with an input terminal of the combination circuit;
a third flip flop with a data input terminal connected with an output terminal of the combination circuit;
a clock input terminal connected with a clock input terminal of the second flip flop and a clock input terminal of the third flip flop; and
a test signal generating section that has an output terminal connected with a data input terminal of the second flip flop and generates a test signal to be supplied to the combination circuit.

11. The semiconductor apparatus according to claim 10, wherein:
a logic of the combination circuit is partly or entirely the same as a real circuit laid out at a position where the combination circuit is actually arranged; and
driving capability of the combination circuit becomes the same as or similar to the real circuit.

12. The semiconductor apparatus according to claim 10, wherein:
the logic of the combination circuit is partly or entirely the same as a real circuit laid out at a position where the combination circuit is actually arranged; and
each cell direction is arranged in the same direction between cells.

13. The semiconductor apparatus according to claim 1, wherein the arithmetic operating section calculates an overall circuit condition of the main circuit reflecting operation performance required for the whole of the main circuit, by statistically processing the detection results of the plurality of sensor circuits.

14. The semiconductor apparatus according to claim 1, wherein the arithmetic operating section generates a control code by statistically processing the detection results of the plurality of sensor circuits.

15. The semiconductor apparatus according to claim 1, wherein the arithmetic operating section statistically processes the delay information including a detected maximum value, minimum value and distribution.

16. The semiconductor apparatus according to claim 1, wherein the power supply voltage controlling section supplies the power supply voltage and potential such that power consumption is minimized within a range where an overall circuit condition of the main circuit satisfies operation performance required for the whole of the main circuit.

17. The semiconductor apparatus according to claim 1, further comprising a substrate bias voltage generating section that supplies substrate potentials to a positive channel metal oxide semiconductor transistor and a negative channel metal oxide semiconductor transistor forming the main circuit,
wherein the substrate bias voltage generating section individually controls the substrate potential of the positive channel metal oxide semiconductor transistor and the substrate potential of the negative channel metal oxide semiconductor transistor according to operation performance required for the whole of the main circuit and an overall circuit condition of the main circuit.

18. The semiconductor apparatus according to claim 1, further comprising a clock generating section that supplies clock signals based on the arithmetic operation result of the arithmetic operating section to the main circuit,
wherein the clock generating section controls the clock signals individually according to operation performance required for the whole of the main circuit and an overall circuit condition of the main circuit.

19. The semiconductor apparatus according to claim 1 further comprising a phase controlling section that supplies phase control signals to the main circuit based on the arithmetic operation result of the arithmetic operating section,
wherein the phase controlling section controls the phasecontrolsignalsindividuallyaccordingtooperation performance required for the whole of the main circuit and an overall circuit condition of the main circuit.

20. The semiconductor apparatus according to claim 1, further comprising a memory that stores the arithmetic operation result of the arithmetic operating section on a temporary basis,
wherein the power supply voltage controlling section controls the power supply voltage supplied to the main circuit based on the arithmetic operation result of the arithmetic operating section stored in the memory.

21. The semiconductor apparatus according to claim 1, further comprising:
a memory that stores the arithmetic operation result of the arithmetic operating section on a temporary basis; and
a substrate bias voltage generating section that supplies substrate potentials to a positive channel metal oxide semiconductor transistor and a negative channel metal oxide semiconductor transistor forming the main circuit, based on the arithmetic operation result of the arithmetic operating section stored in the memory,
wherein the substrate bias voltage generating section individually controls the substrate potential of the positive channel metal oxide semiconductor transistor and the substrate potential of the negative channel metal oxide semiconductor transistor according to operation performance required for the whole of the main circuit and an overall circuit condition of the main circuit.

22. The semiconductor apparatus according to claim 1, further comprising:
a memory that stores the arithmetic operation result of the arithmetic operating section on a temporary basis; and
a clock generating section that supplies clock signals to the main circuit based on the arithmetic operation result of the arithmetic operating section stored in the memory,
wherein the clock generating section controls the clock signals individually according to operation performance required for the whole of the main circuit and an overall circuit condition of the main circuit.

23. The semiconductor apparatus according to claim 1, further comprising:
a memory that stores the arithmetic operation result of the arithmetic operating section on a temporary basis; and
a phase controlling section that supplies phase control signals to the main circuit based on the arithmetic operation result of the arithmetic operating section stored in the memory,
wherein the phase controlling section controls the phasecontrolsignalsindividuallyaccordingtooperation performance required for the whole of the main circuit and an overall circuit condition of the main circuit.

24. The semiconductor apparatus according to claim 1,
wherein the arithmetic operating section and power supply voltage controlling section are built in the main circuit.

25. The semiconductor apparatus according to claim 1, wherein the arithmetic operating section and power supply voltage controlling section are formed with a semiconductor circuit which has a processor including a digital signal processor or an electronic circuit.

26. The semiconductor apparatus according to claim 1,
wherein the arithmetic operating section is a large scale integration tester.
